# FASCICULE DE BREVET EUROPEEN

(11) **EP 2 106 024 B1**
(45) Date de publication et mention de la délivrance du brevet: **07.02.2018**
(21) Numéro de dépôt: 09156165.4
(22) Date de dépôt: 25.03.2009
(51) Int. Cl.: H03H 9/24, H03H 9/02, H03H 3/007, G01R 33/028

(54) **Nano résonateur magnétique**
Magnetischer Nano-Resonator
Magnetic nano-resonator

(30) Priorité: 28.03.2008 FR 0852062
(43) Date de publication de la demande: 30.09.2009
(73) Titulaire: Commissariat à l'Énergie Atomique et aux Énergies Alternatives, 75015 Paris (FR)
(72) Inventeur: Duraffourg, Laurent, 38500 Voiron (FR); Andreucci, Philippe, 38430 Moirans (FR); Bilhaut, Lise, 38000 Grenoble (FR); Viala, Bernard, 38360 Sassenage (FR)
(74) Mandataire: Ilgart, Jean-Christophe

(56) Documents cités:
- WO-A-03/061470
- WO-A-2006/076037
- US-B1- 6 593 731

## Description

### DOMAINE TECHNIQUE ET ART ANTERIEUR

L'invention concerne le domaine des nano résonateurs électromécaniques.

Les nano résonateurs ouvrent la porte à de multiples applications. Ils ont des applications dans le domaine de capteurs « environnementaux », de type biologiques ou chimiques ou de température. Ils peuvent également trouver application dans des capteurs inertiels (accéléromètres, gyromètres).

On peut aussi les utiliser dans des oscillateurs, comme base de temps ou comme filtres.

Un résonateur électromécanique est une structure mécanique mise en vibration par un moyen d'excitation externe (électrodes dans le cas d'une excitation électrique) et dont la déformation (ou le déplacement) est détectée par un autre moyen (autre électrode ou autre principe de transduction).

Les résonateurs peuvent être classés selon les moyens de transduction et d'excitation ou selon leur nature (matériaux et forme géométrique).

Les micros résonateurs électromécaniques sont composés de structures mécaniques vibrantes soit en déformation (flexion d'une poutre) soit en volume (mode d'extension d'une poutre ou d'un disque). Leurs dimensions vont de quelques dizaines de micromètres à plusieurs centaines de micromètres.

Les nano résonateurs sont de petites tailles, leurs sections vont de quelques centaines de nanomètres par quelques centaines de nanomètres à quelques nanomètres par quelques nanomètres. On connaît un système vibrant décrit dans le document US6593731. On connaît un système vibrant décrit dans le document de Roukes et al, Applied Physics Letters, 84, n° 22, 2004, qui met en oeuvre une poutre mise en oscillation sous champ magnétique externe intense (de l'ordre de 6 Teslas) en faisant passer un courant alternatif dans une couche métallique déposée à sa surface.

Dans le même temps, la poutre sert de support à une boucle de courant qui bouge dans un champ magnétique uniforme. Une différence de potentiel apparaît à ses bornes et permet de détecter le mouvement de la poutre. Cette boucle de courant peut être confondue avec le fil métallique servant à l'excitation.

Ce système permet d'obtenir des résultats de mesure de masse avec des sensibilités extrêmes. Plus généralement, les signaux électriques de sortie ont des amplitudes importantes et sortent largement du bruit de fond ce qui permet une détection aisée du signal.

Par contre, ce système n'est clairement pas intégrable et reste une mesure de laboratoire. En effet, il faut utiliser des bobines supraconductrices, sous ultra vide (environ 10⁻⁶ - 10⁻⁷ Torr), et à basse température (quelques Kelvins) pour générer le champ uniforme nécessaire (de 6 à 10 Teslas).

Cette structure n'est pas non plus compatible avec la fabrication d'une électronique de traitement du type de celle placée près d'un NEMS (de type co-intégration ou intégration post-CMOS).

Il se pose donc le problème de trouver un nouveau dispositif de type résonateur électromagnétique, de type nanométrique, qui permette de pallier aux limites des dispositifs actuellement connus, et qui soit notamment intégrable, compatible de préférence avec une fabrication de type MOS, et de faible consommation.

De préférence encore, un tel le dispositif présente des effets de couplages électrostatiques faibles, et un bruit de détection le plus faible possible.

De préférence un tel dispositif est compatible avec plusieurs géométries.

### EXPOSÉ DE L'INVENTION

L'invention concerne un dispositif nano-résonateur selon la revendication 1. On entend par « moyens intégrés à l'élément fixe », ou à l'élément mobile, des moyens formant au moins une partie de cet élément et réalisés de préférence au cours du procédé de formation de cet élément.

On entend par mouvement oscillant, tout mouvement de vibration, y compris à des fréquences autres qu'une fréquence de résonnance.

Un dispositif selon l'invention est totalement intégrable, avec son électronique de traitement tout en minimisant la consommation. En particulier, les moyens électromagnétiques sont sensiblement de même taille que l'élément mécanique associé (c'est-à-dire l'élément fixe ou l'élément mobile).

Un moyen magnétique de forme plane a de préférence une épaisseur totale e petite devant au moins une des deux autres dimensions ou devant chacune des deux autres dimensions, par exemple e est inférieure ou égale 10% de l'une au moins des deux autres dimensions (largeur ou profondeur), les 3 dimensions étant mesurées suivant des directions perpendiculaires de l'espace.

En outre, plusieurs configurations géométriques peuvent être mises en oeuvre dans le cadre de la présente invention.

Selon un mode de réalisation, les premiers moyens électromagnétiques comportent au moins un conducteur de courant, disposé respectivement sur ou dans l'élément mobile ou l'élément fixe, et les deuxièmes moyens électromagnétiques comportent des moyens magnétiques, disposés respectivement sur ou dans l'élément fixe ou l'élément mobile, pour engendrer une aimantation selon une direction perpendiculaire à une direction de circulation du courant dans ledit conducteur.

Le conducteur de courant peut être intégré ou fixé à l'élément mobile (ou fixe), les moyens magnétiques étant intégrés ou fixés à l'élément fixe (ou mobile).

Le conducteur de courant peut être en forme de conducteur rectiligne, ou en forme de boucle de courant.

Des moyens permettent de faire circuler un courant alternatif dans le conducteur de courant, par exemple à au moins une fréquence égale à, ou proche de, une fréquence de résonnance de la partie mobile.

Les moyens magnétiques peuvent comporter au moins un aimant de forme plane, à aimantation dans son plan. Il s'agit par exemple d'un aimant comportant un empilement de couches minces, telles qu'une couche de matériau ferromagnétique (F) et une couche de matériau antiferromagnétique (AF).

Les moyens pour retourner l'aimantation peuvent comporter des moyens pour chauffer la couche de matériau antiferromagnétique au-dessus de la température de blocage de cette couche.

La couche AF bloque l'aimantation de la couche F dans un sens donné. Il est cependant possible d'inverser le sens de cette aimantation. En effet, si la température de la couche AF dépasse une valeur limite (la température de blocage) elle « libère » l'aimantation de la couche F, qui peut alors s'inverser sous l'application d'un champ magnétique. Des moyens peuvent donc être prévus pour chauffer la couche de matériau antiferromagnétique (AF) au-dessus de la température de blocage de cette couche. Ces moyens peuvent comporter un conducteur de courant qui circule sous ou près de l'empilement, et qui peut le cas échéant servir à générer le champ magnétique appliqué à la couche ferromagnétique.

D'autres configurations de ces moyens magnétiques sont possibles.

L'empilement est de préférence limité par deux couches externes dont chacune est une couche antiferromagnétique.

Au moins l'un desdits premiers ou deuxièmes moyens électromagnétiques peut être à aimantation réversible et être associé à des moyens de retournement de l'aimantation.

Les moyens magnétiques peuvent comporter au moins un aimant de forme plane (par exemple réalisée sous forme de couches minces), à aimantation perpendiculaire à son plan, par exemple du type comportant une pluralité de couches CoPt. Des moyens sont par ailleurs prévus pour retourner l'aimantation desdits moyens magnétiques à aimantation perpendiculaire. Par exemple, il est possible de retourner l'aimantation de ce type de couche en l'associant à une couche AF. Pour inverser l'aimantation, on chauffe la couche AF à une température supérieure à sa température de blocage et on applique un champ magnétique de façon à ce que le multicouche prenne l'aimantation désirée (qui se maintiendra lorsque la température de la couche AF repassera sous sa température de blocage).

D'une manière générale, le champ magnétique maximum généré par le ou les moyens magnétiques est inférieur à 2,5 T ou à 1T.

Le mouvement de l'élément mobile peut être un mouvement de flexion ou un mouvement de torsion ou de rotation, toute déformation en volume (en translation pure).

Parmi les géométries possibles on a les suivantes:
- deux aimants peuvent être disposés sur ou dans la partie fixe, de part et d'autre d'un plan contenant un axe de rotation de la partie mobile ; celle-ci peut comporter une plaque ou une poutre ou un élément planaire s'étendant de part et d'autre de l'axe de rotation ; une boucle de courant peut être disposée sur la, ou dans, la partie mobile.
- un ou deux aimants peuvent être disposés sur ou dans la partie fixe ; dans le cas de deux aimants, ils peuvent être déposés de part et d'autre d'un plan contenant une direction de déplacement de la partie mobile.

### BRÈVE DESCRIPTION DES DESSINS

- Les figures 1A et 1B représentent un aimant à aimantation parallèle à son plan, réversible ou non.
- Les figures 1C et 1D représentent un aimant à aimantation parallèle à son plan, réversible, en vue de dessus, avec les lignes de courant permettant d'obtenir la réversibilité.
- Les figures 1E et 1F représentent d'autres empilements de moyens magnétiques pouvant être mis en oeuvre dans le cadre de la présente invention.
- Les figures 2A et 2B représentent un aimant à aimantation perpendiculaire à son plan, réversible ou non.
- La figure 2C représente un aimant à aimantation perpendiculaire à son plan, réversible, en vue de dessus.
- Les figures 3A et 3B sont des exemples de réalisation d'un nano oscillateur à actionnement magnétique avec une aimantation perpendiculaire à son plan, respectivement avec mouvement dans le plan, en flexion, et avec mouvement d'extension dans le plan, en volume.
- Les figures 4A et 4B sont des exemples de réalisation d'un nano oscillateur à actionnement magnétique avec une aimantation parallèle à son plan.
- La figure 4C est un exemple de réalisation d'un nano oscillateur à actionnement magnétique, avec un aimant fixé à la partie mobile.
- Les figures 5A et 5B sont des exemples de réalisation de nano oscillateurs à actionnement magnétique avec conducteur et élément mobile disposés partiellement entre deux aimants et à mouvement de flexion hors plan.
- Les figures 6A et 6B sont des exemples de réalisation de nano oscillateurs à actionnement magnétique avec élément mobile en rotation.
- Les figures 7A à 7D concernent un nano oscillateur à actionnement magnétique avec des aimants à aimantation perpendiculaire, et mouvement de compression ou de dilatation.
- Les figures 8A et 8B représentent un nano oscillateur à actionnement magnétique avec des aimants parallèles et retournement des pôles, et mouvement de torsion ou de flexion hors plan.
- Les figures 9A et 9B représentent un nano oscillateur à actionnement magnétique avec des aimants parallèles et retournement des pôles, et mouvement en pivot dans le plan d'une plaque liée à une charnière souple.
- Les figures 10A-10K, 11A-11L, 12A-12J représentent des étapes de divers procédés de réalisation d'un dispositif selon l'invention.

### DESCRIPTION DETAILLEE DE MODE DE REALISATION DE L'INVENTION

Dans le suivant un dispositif selon l'invention comporte les caractéristiques techniques selon la revendication 1. Un dispositif selon l'invention comporte une partie fixe et une partie mobile par rapport à la partie fixe. La partie mobile comporte une structure mécanique, il s'agit par exemple d'une plaque ou une poutre, et sera dans la suite désignée par l'un ou l'autre de ces termes. Le gap, ou la distance, entre partie fixe et partie mobile (lorsque cette dernière est au repos) est inférieur à 1 µm, par exemple de l'ordre de 200 nm ou 100 nm, ou inférieur à 200 nm ou 100 nm, par exemple comprise entre 10 nm et 50 nm.

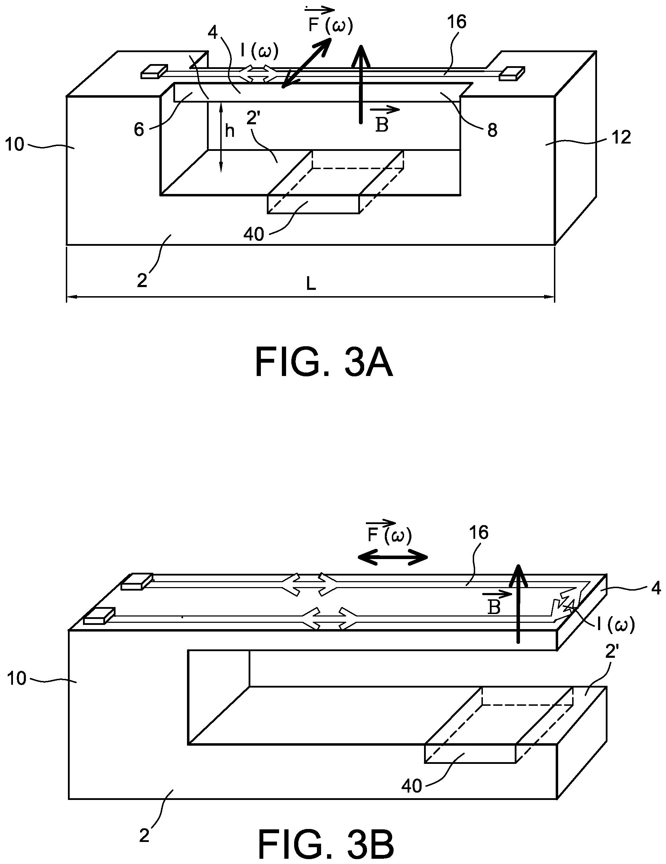

Cette partie mobile peut avoir une souplesse qui lui permet de venir en partie au contact de la partie fixe, sous l'action du torseur des forces électromagnétiques, ou qui lui permet d'être fléchie d'une certaine amplitude comme l'indique la flèche F des figures 3A, 3B, 4A-4C ou 8B ou 9A, 9C.

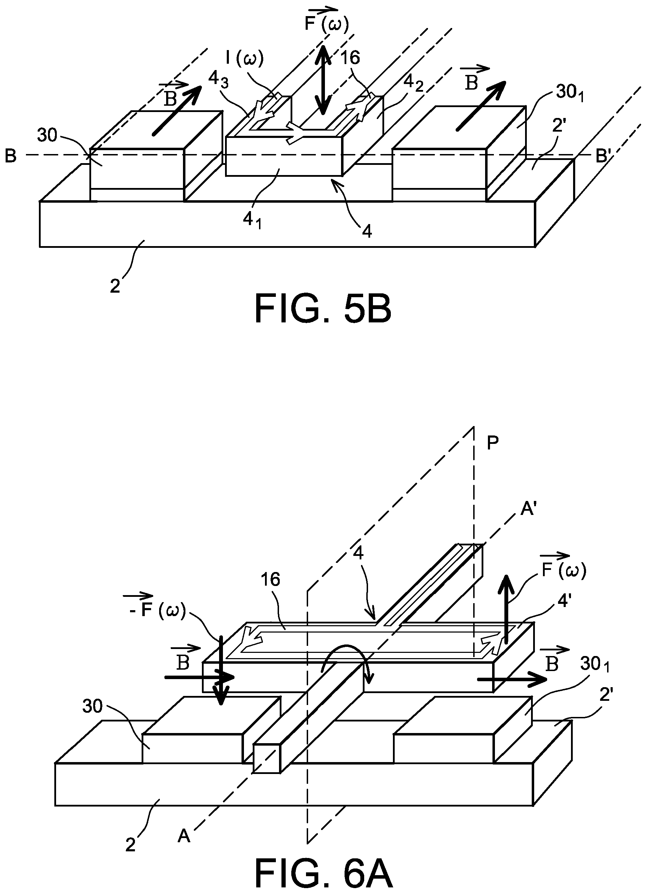

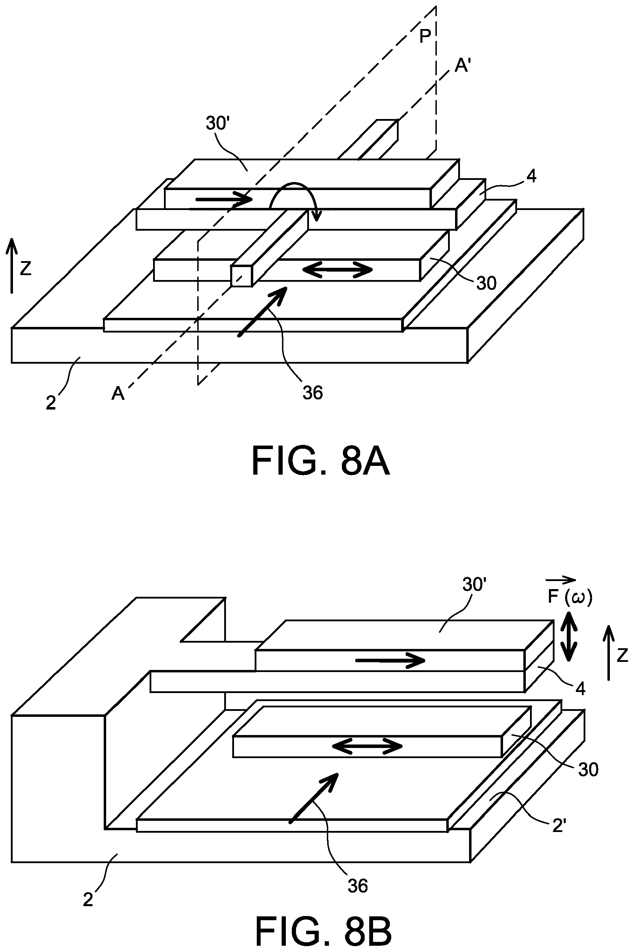

Dans d'autres modes de réalisation, elle est mise en rotation autour d'un axe (cas des figures 6A-6B ou 8A).

Un dispositif selon l'invention met en oeuvre des moyens magnétiques, ou aimants, de forme plane, à aimantation rémanente, soit irréversible soit réversible, dans le plan des moyens magnétiques ou perpendiculairement à ce plan. Dans le cas d'une aimantation rémanente, la réversibilité peut être obtenue par chauffage et application d'un champ magnétique externe suivant la direction désirée et le sens désiré.

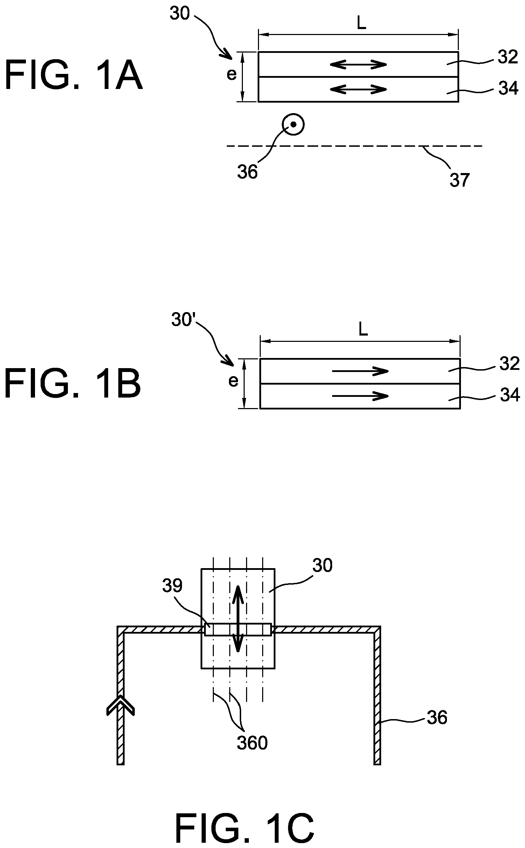

Un exemple de moyens magnétiques 30, ou nano-aimant, à aimantation plane et retournable est représenté en figure 1A et comporte une couche 32 de matériau ferromagnétique (F) et une couche 34 d'un matériau antiferromagnétique (AF). Ces deux couches forment un élément planaire, puisque l'épaisseur totale e de ce dernier est petite devant au moins une des deux autres dimensions, et éventuellement devant chacune des deux autres dimensions ; par exemple e est inférieure ou égale 10% de l'une au moins des deux autres dimensions. À titre d'exemple, cette épaisseur e est comprise entre environ 50 nm et 150 nm, par exemple égale à environ 110 nm, pour une largeur L (mesurée dans le plan de la figure 1A) de l'ordre de grandeur de quelques µm à quelques dizaines de micromètres, par exemple entre 5 µm et 50 µm, par exemple encore de l'ordre de 40 µm. Sa profondeur (dimension perpendiculaire au plan de la figure) est de l'ordre de grandeur de quelques µm à quelques dizaines de micromètres, par exemple entre 5 µm et 50 µm. Le rapport L/e peut donc être d'au moins 30 ou 100.

Les dimensions latérales peuvent être plus petites que celles indiquées ci-dessus. Par exemple la profondeur peut être de l'ordre de quelques centaines de nm, par exemple égale à environ 200 nm. Avantageusement, avec un aimant situé en dessous de l'élément mécanique, les dimensions de cet aimant seront de l'ordre de quelques micromètres, ce qui permet d'assurer une bonne uniformité du champ magnétique.

À cet ensemble est associé un moyen de chauffage, par exemple une ou plusieurs lignes de courants 36 disposées contre la couche 34 antiferromagnétique, ou de manière proche de cette couche. Avantageusement, une couche intermédiaire de matériau, par exemple TiN ou GeSbTe, apte à dégager de la chaleur sous l'action d'un courant électrique (thermistance) peut être disposée entre la ligne 36 et la couche 34. Mais, de manière avantageuse, cette dernière est au plus près de la ligne de courant 36, afin qu'un chauffage le plus efficace possible puisse être assuré. La ou les lignes 36 sont de préférence rectilignes afin de générer un champ magnétique transverse (dans le plan de la couche 34) le plus homogène possible. Dans la suite on limite la description au cas d'une seule ligne de courant, mais le cas de deux lignes s'en déduit aisément.

La couche 34 AF bloque l'aimantation de la couche 32 dans un sens ou dans l'autre, dans le plan de l'élément 30. Le champ généré par l'ensemble est également localement dans le plan de l'élément 30.

Cependant, si la température dépasse une valeur limite (la température de blocage, déterminée par la couche 34 antiferromagnétique, par exemple 150°C, mais elle peut être supérieure, par exemple comprise entre 150°C et 250°C) l'aimantation de la couche 32 peut s'inverser, tout en restant dans le plan de l'élément 30, sous l'application d'un champ magnétique. En d'autres termes, le dépassement de la température de blocage de la couche 34 permet de libérer l'aimantation de la couche ferromagnétique. L'aimantation se maintient dans le nouveau sens lorsque la température de la couche AF repasse sous sa température de blocage.

Cette température de blocage peut être atteinte et dépassée, par application d'un courant I dans la ligne de courant 36. Le chauffage ainsi produit par effet Joule va être transmis à la couche 34. Cette ligne de courant 36 va également permettre d'induire un champ magnétique, qui va orienter l'aimantation de la couche ferromagnétique 32 et permettra de faire basculer cette aimantation.

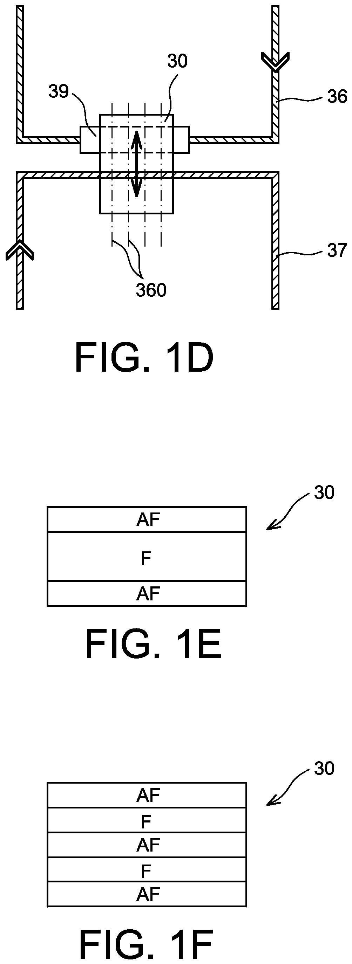

L'empilement de couches magnétiques dans les moyens magnétiques, à aimantation plane et retournable, peut comporter des variantes plus complexes, qui permettent de mieux contrôler l'alimentation de la couche F. Par exemple, un empilement comporte, comme illustré sur la figure 1E, une couche F prise en sandwich entre deux couches AF. Par exemple encore, la structure de la figure 1F peut être réalisée: elle comporte l'empilement suivant couche AF/couche F/couche AF/couche F/couche AF. Un nombre quelconque de couches, alternativement F et AF, peut être prévu. De préférence, c'est un nombre impair de couches, avec une couche AF qui limite l'empilement à chacune de ses extrémités, en d'autres termes, l'ensemble des couches est compris entre deux couches AF, comme sur les figures 1E et 1F.

Quel que soit l'empilement retenu, il n'y a pas de couche intercalaire entre les couches magnétiques.

La figure 1C est une vue de dessus du dispositif de la figure 1A, où l'on reconnaît l'élément 30. Une thermistance 39 est avantageusement disposée sous l'élément 30 et sur le chemin du courant amené par la ligne 36 afin d'augmenter le transfert de chaleur vers celui-ci.

Au lieu d'une seule ligne de courant, on peut avoir 2 (ou plusieurs) lignes, une ligne 37 (représentée en traits interrompus sur la figure 1A) permettant d'augmenter la température au-dessus de la température de basculement, et une ligne 30 pour engendrer le champ magnétique qui va permettre d'orienter et de bloquer l'aimantation dans la couche 32. C'est ce que représente également la figure 1D, qui est également une vue de dessus d'un tel dispositif, où l'on reconnaît encore l'élément 30 et une thermistance 39 disposée sous l'élément 30 et sur le chemin du courant amené par la ligne 36, afin d'augmenter le transfert de chaleur vers celui-ci. Mais une deuxième ligne 37 de courant passe également sous l'élément 30 et permet de générer un champ magnétique dans ce dernier. La deuxième ligne 37 est également représentée en figure 1A, en traits interrompus.

Dans les deux cas exposés ci-dessus la thermistance 39 peut être par exemple en TiN ou en TaN ou en GeSbTe.

Sur les deux figures 1C et 1D sont également représentées les lignes du champ 360 généré par le courant circulant dans la ligne 36 (figure 1C) ou dans la ligne 37 (figure 1D).

On peut donc retourner l'aimantation de la couche 32, et donc le champ généré par l'élément 30 dans son propre plan, grâce aux conducteurs 36 et 37, appliqué(s) contre ou au voisinage de l'élément 30.

Une fois l'aimantation de la couche 32 retournée, elle génère un champ magnétique dans le plan de l'élément 30, de sens opposé à celui qu'elle générait avant.

Avantageusement on utilise un unique conducteur 36 pour assurer la fonction de chauffage et d'application de champ magnétique (cas de la figure 1A sans le conducteur 37).

Dans un mode de réalisation avantageuse, on place une thermistance (couche de TiN ou GeSbTe) entre le conducteur 36 et l'empilement 30 de façon à confiner la chaleur au voisinage de la couche 34.

Il est possible d'utiliser :
- en tant que matériau de couche AF antiferromagnétique le PtMn ou le NiMn (température de blocage importante), qui peut être associé au CoFe, ou au NiFe en tant que matériau de couche ferromagnétique;
- ou, en tant que matériau de couche antiferromagnétique, l'IrMn ou le FeMn, qui a une température de blocage moins élevée que PtMn, ou NiMn, et qui peut être associé au NiFe ou au CoFe en tant que matériau de couche ferromagnétique

Il est possible de mettre en oeuvre ces couples de matériaux (AF, F) : (PtMn, CoFe), (PtMn, NiFe), (NiMn, CoFe), (NiMn, NiFe) (pour lesquels Tb est importante) et (IrMn, NiFe), (IrMn, CoFe) (pour lesquels Tb est moins importante), dans le cadre de la présente invention. On peut également mettre en oeuvre les couples (AF, F) de matériaux (FeMn, NiFe), (FeMn, CoFe) .

Pour obtenir une aimantation forte, on utilise le matériau CoFe, qui a une aimantation de 2,4 T (alors que NiFe a une aimantation de 1 T). On utilise donc alors, de préférence, les couples (AF, F) suivants : (PtMn, CoFe), (NiMn, CoFe), (IrMn, CoFe), (FeMn, CoFe).

Un procédé de réalisation des couches 32, 34 est par exemple un procédé par pulvérisation cathodique, ou ionique (PVD, IBD « ion beam deposition »).

Une variante 30' de cet élément, sans conducteur 36, 37 (figure 1B), peut aussi être mise en oeuvre dans certains modes de réalisation. L'aimantation de la couche ferromagnétique 32 reste alors fixée ou bloquée par la couche antiferromagnétique 34 AF dans le plan de cet élément 30'. En variante, on peut avoir un empilement à plusieurs couches F/AF, par exemple AF/F/AF/F/AF, comme expliqué ci-dessus et dans les structures des figures 1E et 1F. Les épaisseurs des couches F (ferromagnétiques) sont alors dimensionnées pour éviter le rebouclage du champ d'une couche F dans une autre couche F.

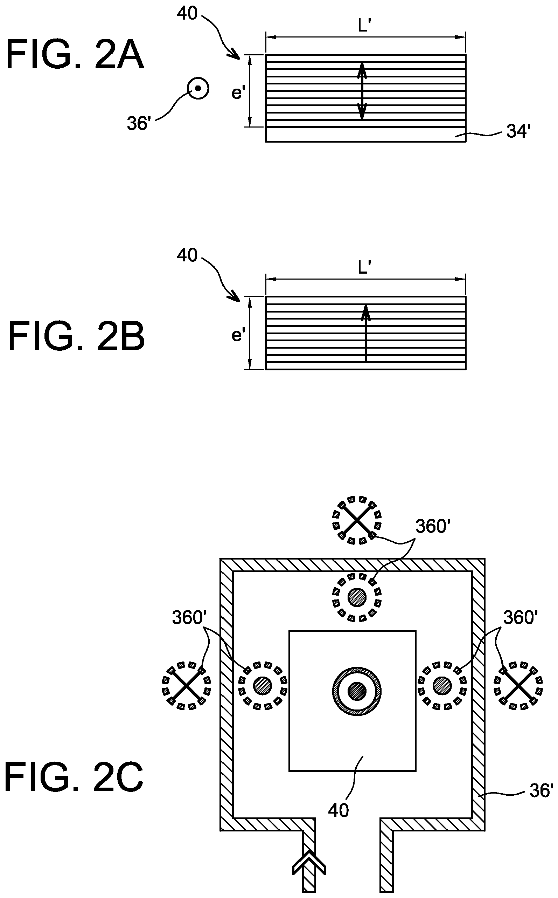

Un exemple des moyens 40, ou nanoaimants, à aimantation perpendiculaire, est représenté en figure 2A. Ces moyens comportent un aimant, réalisé en couches minces, de forme plane, à champ perpendiculaire à son plan et, là encore, au moins une couche 34 d'un matériau antiferromagnétique (AF), par exemple en IrMn ou en PtMn ou en NiMn. Il peut y avoir deux couches antiferromagnétiques 34, 34', disposées d'un côté et/ou de l'autre côté de l'empilement 40 de couches minces.

On peut retourner l'aimantation à l'aide de moyens 36' conducteurs (figure 2C), dans le cas où l'élément 40 est en contact avec une ou plusieurs couches antiferromagnétiques, par exemple en IrMn. Par exemple une bobine entoure l'élément 40 et est disposée dans un plan sensiblement perpendiculaire à la direction du champ engendré.

Le retournement de l'aimantation rémanente se fait par effet thermique, comme dans le cas des composants de la figure 1A. Il y a la possibilité d'avoir deux conducteurs, comme dans le cas de la figure 1D, l'un permettant de chauffer les couches antiferromagnétiques, l'autre permettant d'appliquer le champ magnétique.

Le conducteur mis en oeuvre pour le chauffage peut comporter, comme expliqué ci-dessus, une thermistance, par exemple en TiN ou en TaN ou en GeSbTe.

Un autre exemple de moyens 40' permettant d'engendrer une aimantation rémanente perpendiculaire à son plan et permanente est représenté en figure 2B. Là encore, ces moyens comportent un empilement de couches minces et ils sont de forme plane.

Dans le cas des deux figures 2A et 2B, l'épaisseur e' est très inférieure aux deux autres dimensions, ou en tout cas différente par au moins un ordre de grandeur, de ces deux autres dimensions. Cet aimant est de type multicouches CoPt ou en d'autres matériaux. Pour le matériau antiferromagnétique (AF) de la couche 34' des exemples de matériaux ont déjà été indiqués ci-dessus.

La figure 2C représente une vue de dessus du dispositif de la figure 2A. Les moyens 40, avec aimantation rémanente perpendiculaire, sont entourés par une bobine 36' qui chauffe la couche AF et génère le champ magnétique 360' de renversement de l'aimantation.

Le choix du matériau dépendra de son aptitude à engendrer une aimantation perpendiculaire, et ceci tout en tenant compte également de l'épaisseur des couches constituant l'empilement 40. À titre d'exemple, une aimantation rémanente à la surface de l'empilement 40 ou 40', inférieure à 1 T, de l'ordre de quelques dixièmes de tesla, par exemple 0,6 T, ou encore supérieur à 0,3 ou 0,5 T, convient pour une application à un nano-oscillateur selon l'invention ou à un nano-oscillateur selon l'invention.

À titre d'exemple encore, on peut citer, pour l'empilement 40, 40' des figures 2A-2B, une épaisseur e' comprise entre 10 nm et 20 nm, par exemple 15 nm (hors couches antiferromagnétiques 34, 34'), pour une largeur L' de l'ordre de quelques centaines de nanomètres, par exemple comprise entre 100 nm et 500 nm, par exemple égale à 400 nm. L'épaisseur e' indiquée signifie que chacune des couches de l'empilement 40 peut avoir elle-même une épaisseur de l'ordre du nanomètre, par exemple comprise entre 0,5 nm et 1,5 nm. Sa profondeur peut être égale à L', ou de l'ordre de grandeur de L'. Une couche AF 34, 34' a une épaisseur sensiblement égale à quelques nanomètres, par exemple 10 nm, soit 20 nm pour deux couches AF 34, 34'.

L'empilement 40, 40' peut être réalisé par exemple par pulvérisation cathodique de couches, alternativement de cobalt et de platine; on obtient donc un motif (Co/Pt)n, où n est le nombre de répétitions de l'empilement platine/cobalt. On peut procéder de même avec d'autres compositions.

Ces structures d'aimants permettent d'obtenir des champs magnétiques suffisamment intenses à l'échelle sub-micrométrique pour un actionnement mécanique, et d'intégrer les aimants dans un nano-oscillateur.

Les champs magnétiques utiles peuvent donc être largement réduits par rapport à l'état de l'art (on rappelle la valeur de au moins 6 Teslas pour l'art antérieur). Ici les matériaux intégrables pour réaliser ces aimants génèrent des champs inférieurs à 2,5 T, par exemple de l'ordre de 1 à 2,4 Teslas, pour les multicouches AF/F et inférieurs à 1 T, par exemple de l'ordre de 0,6 Tesla, pour les multicouches à aimantation perpendiculaire.

Des aimants en couche mince existent dans la littérature, mais leurs dimensions restent de l'ordre de plusieurs centaines de micromètres et ils perdent leurs propriétés magnétiques lorsqu'on les réduit.

Selon la nature du mouvement d'oscillation que l'on cherche (en flexion ou en torsion ou en translation, ou en expansion ou en contraction) et sa direction (dans le plan ou hors plan), et selon les positions relatives de la poutre et de l'aimant, on pourra utiliser l'aimant perpendiculaire et/ou soit l'aimant parallèle.

Afin d'améliorer éventuellement les architectures de base, une composition d'aimants parallèles (à aimantation variables ou/et fixes) et/ou perpendiculaires peut être réalisée (notamment pour réaliser des mesures différentielles améliorant le rapport signal/fond continu lorsque l'oscillateur est utilisé en capteur).

Dans les exemples qui suivent, des références identiques désignent des éléments identiques ou similaires.

Un exemple d'un système de nano-résonateur selon l'invention, est illustré sur la figure 3A.

Dans cet exemple, un nano- résonateur comporte une partie mobile, par exemple une poutre, référencée 4 sur la figure 3A. Cette partie mobile est dans sa position de repos sur la figure. Elle est fixée, par ses deux extrémités 6, 8, à des parties latérales 10, 12 d'un socle fixe 2. Des moyens magnétiques 40 formant un nanoaimant, permettant d'engendrer une aimantation B perpendiculaire à la surface 2' du socle 2, sont disposés dans ou sur ce socle 2. La partie mobile, dans cet exemple, est en un matériau conducteur, ou bien un conducteur 16 est formé ou déposé sur ou dans cette partie mobile.

Le gap h entre l'élément mécanique au repos et l'aimant est de l'ordre de, ou inférieur à, 1 µm ou 200 nm ou même 100 nm,Par exemple, il est compris entre 10 nm et 50 nm.

Lorsque la partie mobile 4 est activée, par l'action combinée des moyens magnétiques 40 et d'un courant I alternatif circulant dans le conducteur 16 associé à la partie mobile 4, celle-ci est mise en résonance (en fonction de la fréquence ω du courant I). il se produit alors un mouvement en flexion dans le plan de la plaque. Le système de la figure 3A permet de réaliser un mouvement de flexion de la partie mobile 4, parallèlement au substrat 2 (en oscillant suivant la direction de la flèche F).

La figure 3B est une variante, dans laquelle la partie mobile est fixée à une seule de ses extrémités à un socle 10 solidaire d'un substrat 2. Là encore, un conducteur 16 permet de faire circuler un courant alternatif qui va interagir avec le champ magnétique perpendiculaire (à la surface 2') généré par les moyens 40. Sur cette figure, le conducteur est en forme de boucle de courant, dans un plan de la partie mobile 4 sensiblement parallèle au plan supérieur 2' du substrat 2. L'interaction du champ magnétique et d'un courant alternatif de fréquence ω se déplaçant dans cette boucle va conduire à l'application d'une force F oscillante, comme indiqué sur la figure 3B. Cette force est contenue dans le plan de la partie mobile 4. Il en résulte un mouvement, alternativement d'extension et de compression, en volume, de la partie 4, suivant la direction de cette force F.

Les modes de réalisation des figures 3A et 3B sont à actionnement magnétique avec aimant 40 à aimantation perpendiculaire (comme sur les figures 2A et 2B).

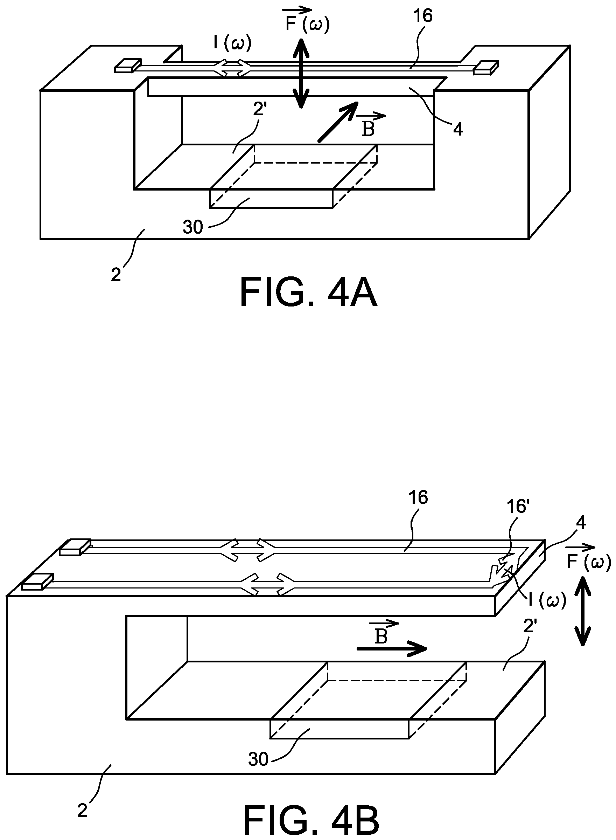

On peut mettre en oeuvre un actionnement magnétique avec aimant à aimantation parallèle (comme sur les figures 1A et 1B). Ainsi, dans le mode de réalisation de la figure 4A, avec partie mobile fixée à ses deux extrémités, on réalise un mouvement de flexion hors du plan de la partie mobile 4 (ou dans un plan perpendiculaire à la surface 2' de la partie fixe 2). Le champ B engendré par les moyens magnétiques 30, à aimantation parallèle, est, cette fois, contenu dans le plan du substrat 2 (ou parallèle à la surface 2' de ce substrat). Il interagit avec le courant I (alternatif) circulant dans la ligne 16. La force F(ω) qui en résulte est perpendiculaire au plan de substrat 2, et la poutre 4 vibre donc également suivant cette direction.

Dans le mode de réalisation de la figure 4B, avec partie mobile fixée à une seule de ses deux extrémités, on réalise un mouvement de flexion hors du plan de la partie mobile 4. Le champ engendré par les moyens magnétiques 30 est, cette fois, parallèle au plan du substrat 2. Le conducteur disposé sur la partie mobile a la forme d'une boucle de courant. Le champ magnétique interagit avec un courant alternatif I(ω) circulant dans cette boucle. Dans le mode de réalisation illustré, c'est en fait avec le courant circulant dans la partie 16' (le bas du « U », ou la partie de la boucle de courant la plus proche de l'extrémité libre de la poutre 4) qui interagit avec B, dirigé suivant la direction d'élongation de la plaque 4. La force F(ω) qui en résulte est perpendiculaire au plan de substrat 2, et la poutre 4 vibre donc également suivant cette direction.

Dans tous ces modes de réalisation, l'oscillation de la partie mobile est obtenue en utilisant un courant alternatif (sinusoïdal ou carré) dans les moyens conducteurs 16, de préférence à une fréquence de résonance de la poutre (différents modes pouvant être éventuellement excités).

On peut obtenir, en choisissant l'aimant (aimantation parallèle ou perpendiculaire, réversible ou pas), et le positionnement de son aimantation par rapport au conducteur ou à la boucle de courant de la partie mobile, tous les mouvements, hors du plan défini par la position, au repos, de l'élément mobile, et/ou dans ce même plan.

Il est en outre possible de générer des forces d'extension susceptibles de faire vibrer la structure en volume afin d'atteindre des fréquences de vibration plus hautes, qui peuvent être mises en oeuvre dans des applications de type « base de temps » (on peut donc atteindre des fréquences de l'ordre de 1 GHz ou plus).

Dans les exemples qui viennent d'être décrits, ou dans ceux qui seront décrits par la suite, le conducteur 16 ou la boucle de courant peut être:
- métallique (Pt, Al, Cu, Au, AlSi, ...) déposée sur la poutre (ou plus généralement sur la structure mécanique). En fonction des applications visées, elle peut avoir une épaisseur variant de quelques dizaines de nanomètres à plusieurs centaines de nanomètres, par exemple compris entre 10 nm et 500 nm. Ces couches métalliques sont peu résistives, ce qui permet de minimiser l'impact du bruit de Johnson.
- ou résulter d'un procédé de siliciuration (elles sont par exemple en NiSi, ou en PtSi, ou en TiSi₂, ou en WSi₂ ...),
- ou constituée par la poutre 4 elle-même, notamment si celle-ci est dopée : le dopage peut alors avoir lieu avant le procédé de fabrication, par exemple lors d'une épitaxie initiale de Si dopé sur la plaquette ; il peut aussi avoir lieu pendant le procédé de fabrication, par implantation sur des épaisseurs réglables en fonction de la dose et de l'énergie des dopants.

Dans les exemples qui viennent d'être décrits, ou dans ceux qui seront décrits par la suite, l'élément mécanique mobile 4 peut être :
- directement réalisé dans une couche métallique (en un matériau tel que Ru, ou AlSi, ...),
- ou structuré dans du silicium ou tout autre dérivé (Si poly, ou SiN, ...). Le silicium peut être non dopé ou dopé partiellement ou encore dopé dans toute son épaisseur selon les configurations choisies.

Dans les modes de réalisation ci-dessus, les moyens 16 de conducteurs de courant sont disposés sur, ou intégrés dans, la partie mobile et les moyens magnétiques, sur ou dans la partie fixe. Mais pour chacune des configurations présentées, la configuration inverse est possible: les moyens magnétiques 30, 40 peuvent être disposés dans ou sur la partie 4 qui est mécaniquement mobile, tandis que les moyens 16 de conducteurs de courant sont disposés dans ou sur la partie fixe 2. La force qui résulte de l'interaction champ magnétique-courant s'appliquera de manière à provoquer l'un des déplacements, déjà décrits ci-dessus, de la partie mobile par rapport à la partie fixe.

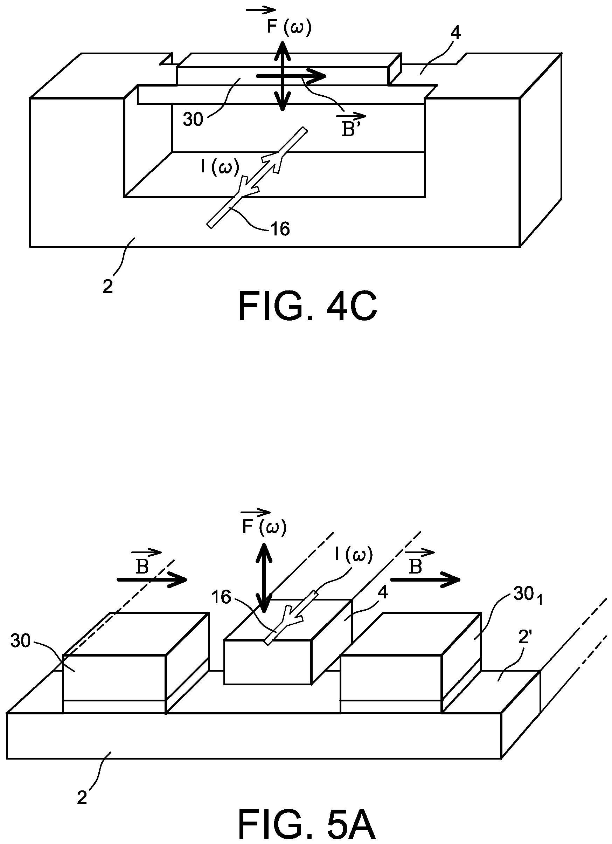

Ainsi, la figure 4C illustre une structure qui est, mécaniquement du type de celle de la figure 4A, mais dans laquelle la position des moyens magnétiques 30 et des moyens conducteurs 16 est inversée. Cette structure est à partie mobile fixée à ses deux extrémités. On réalise un mouvement de flexion hors du plan de la partie mobile 4 (ou dans un plan perpendiculaire à la surface 2' de la partie fixe 2). Le champ B engendré par les moyens magnétiques 30 (disposés sur ou dans la partie mobile 4), à aimantation parallèle, est, là encore, parallèle à la surface 2' du substrat 2. Il interagit avec le courant I (alternatif) circulant dans la ligne 16, disposée sur ou dans la partie fixe 2. La force F(ω) qui en résulte est perpendiculaire au plan de substrat 2, et la poutre 4 vibre donc également suivant cette direction.

Dans les modes de réalisation et leurs variantes décrits ci-dessus, les moyens de conducteurs de courant et les moyens magnétiques sont situés dans deux plans différents, parallèles à la surface 2' de la partie fixe 2.

D'autres architectures permettent une réalisation, dans un même plan, ou sensiblement dans un même plan, des éléments que constituent les moyens conducteurs 16 et les moyens magnétiques 30, 40.

On peut ainsi obtenir des mouvements de flexion ou des mouvements de torsion.

Deux exemples de ce type de dispositif, avec mouvement de flexion, sont illustrés sur les figures 5A et 5B.

Dans ces exemples, des moyens magnétiques 30, 30₁, à aimantation parallèle, sont disposés de part et d'autre de la partie mobile 4 (ici: une poutre), qui peut avoir une forme linéaire (figure 5A) ou une forme de « U » (figure 5B).

Les moyens 16 conducteurs de courant, disposés sur ou dans la partie mobile, ont, dans la zone d'interaction avec les moyens magnétiques, la forme correspondante, linéaire ou en U.

Dans le deuxième cas (figure 5B), la partie de retour du courant (la base du « U ») est située le plus près possible des moyens magnétiques, sensiblement entre les aimants 30, 30₁. De manière plus précise, la partie 4, en U, comporte une première section 4₁, disposée parallèlement à un axe BB' qui relie les deux aimants, et deux sections latérales 4₂, 4₃ dont chacune est reliée à une extrémité de la première section 4₁. L'ensemble, constitué par les diverses sections du «U » et par les aimants 30, 30₁ est situé sensiblement dans un même plan, parallèle à la surface 2' du substrat 2.

Pour ces deux structures, le mouvement est un mouvement de flexion, perpendiculairement au plan défini par la surface 2' de la partie fixe 2.

Le champ engendré par les moyens magnétiques 30, 30₁ est sensiblement contenu dans le plan du substrat 2 et il interagit avec le courant circulant dans la ligne ou la boucle 16. En fait, il interagit avec la portion du conducteur 16 par rapport à laquelle il est dirigé de manière sensiblement perpendiculaire. La force F(ω) qui en résulte est perpendiculaire au plan du substrat 2, et la poutre 4 ou, plus généralement, l'élément mobile 4, vibre donc également suivant cette direction.

En variante, dans les deux cas, seuls les moyens magnétiques 30 sont disposés sur ou dans la partie fixe. Autrement dit, les moyens 30₁ sont optionnels et leur suppression permet néanmoins l'obtention d'un mouvement de flexion hors plan. Le déplacement (flexion) de la partie mobile 4 se fait également hors du plan. Lorsque deux aimants sont disposés de part et d'autre de l'élément mobile, ils ont la même direction d'aimantation.

On peut on avoir une situation au moins partiellement symétrique avec le conducteur 16 disposé sur ou dans la partie fixe et l'aimant sur ou dans la poutre la partie mobile.

Dans le cas des structures des figures 5A et 5B, comme d'ailleurs dans les autres exemples de réalisation, l'amplitude du mouvement de la poutre peut être contrôlée (par une boucle fermée et une électronique intégrée par exemple).

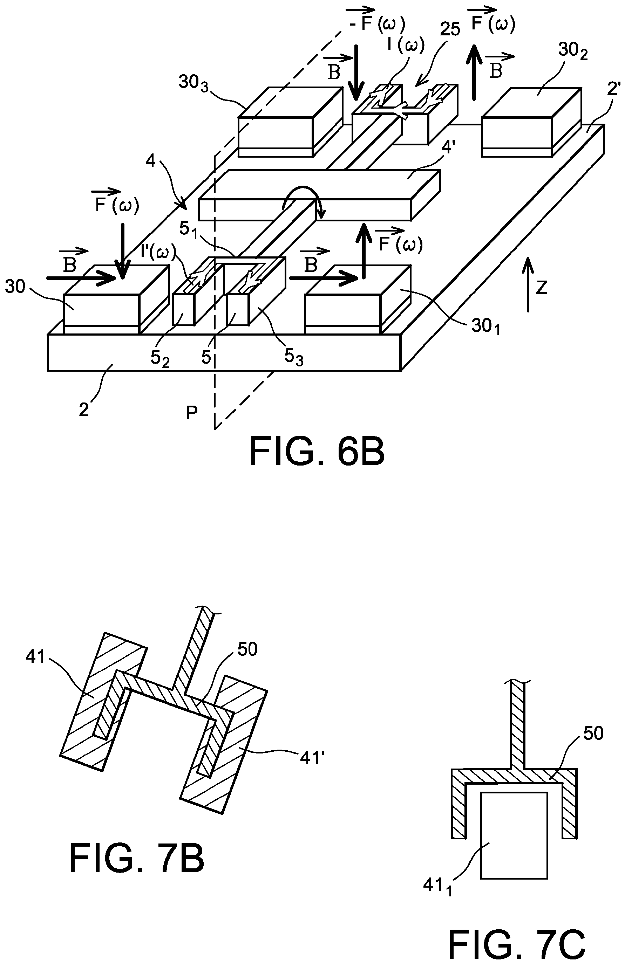

Dans un autre mode de réalisation, la partie mobile est mobile autour d'un axe de rotation. Deux exemples de ce type de mouvement sont illustrés sur les figures 6A et 6B. Il s'agit de nano oscillateur à actionnement magnétique avec des aimants parallèles.

Le cas de la figure 6A permet de réaliser un mouvement de torsion hors plan d'une plaque autour d'un axe formé par deux poutres simples, et les aimants sont positionnés sous la plaque.

Dans ce premier exemple des aimants 30, 30₁, chacun à aimantation parallèle, et dont les aimantations sont dirigées dans le même sens, sont réalisés sur, ou dans, le substrat fixe 2, de part et d'autre d'un plan P perpendiculaire au plan de la surface 2' du substrat fixe 2. Ce plan P contient un axe AA' de rotation de la partie mobile 4, lui aussi parallèle au plan de la surface 2'. La partie mobile comporte en outre un élément planaire 4', qui s'étend de part et d'autre de l'axe de rotation AA', et sur laquelle se trouve une boucle de courant 16. Au repos, cet élément planaire 4 est disposé sensiblement parallèlement à la surface 2'.

Chacune des parties latérales de l'élément planaire 4', de part et d'autre de l'axe AA', s'étend au-dessus de l'un des aimants 30, 30₁. La portion de la boucle 16 de courant qui circule sur ou dans cette partie va donc interagir avec le champ magnétique de l'aimant au-dessus duquel elle est située. Suivant la direction du courant dans la boucle, l'interaction avec le champ magnétique B permettra de faire subir à l'élément planaire 4' une rotation (plaque en rotation) ou une torsion (du bras) autour de l'axe AA', dans un sens ou dans l'autre.

En d'autres termes, l'élément mobile subit un couple de forces électromagnétiques [F(ω), -F(ω)], induites par les aimants 30, 30₁ (voir figure 6A). En fait, le champ magnétique interagit essentiellement, aux extrémités de la plaque, avec la portion de la boucle de courant par rapport à laquelle il est sensiblement perpendiculaire.

Dans un deuxième exemple (voir figure 6B), des aimants 30, 30₁, 30₂, 30₃ sont réalisés ou placés sur ou dans le substrat fixe 2, de part et d'autre d'un plan P perpendiculaire au plan 2' du substrat fixe et comportant un axe AA' de rotation de la partie mobile, disposé de manière sensiblement parallèle au plan 2'. Les aimants sont à aimantation parallèle à la surface 2' du substrat 2. Les deux aimants 30, 30₁ situés à une extrémité du dispositif génèrent un champ magnétique qui a une orientation opposée à celle du champ généré par les deux aimants situés à l'autre extrémité du dispositif. D'autres configurations sont possibles, en fonction des orientations relatives de I et de B

Comme sur la figure 6A, la partie mobile 4 comporte, en outre, un élément planaire 4', qui s'étend de part et d'autre de l'axe de rotation AA'. Ce dernier est prolongé, à chacune de ses extrémités, par une portion 5, 25 en forme de « U » qui porte une boucle de courant, en forme de « U » également. De manière plus précise, la portion 5, par exemple, comporte une première section 5₁, disposée perpendiculairement à l'axe AA', et deux sections latérales 5₂, 5₃ dont chacune est reliée à une extrémité de la première section 5₁. La portion 25 peut avoir la même structure.

Chacune des deux extrémités en forme de U est disposée de manière sensiblement parallèle au plan de la surface 2' et entre les aimants associés à cette extrémité. On notera que, à chaque extrémité, on peut surélever les aimants pour assurer un champ qui soit bien perpendiculaire à la ligne de courant.

Pour chaque portion d'extrémité, la portion de boucle de courant qui y circule va donc interagir avec le champ magnétique des aimants entre lesquels elle est située. En fait, le champ interagit essentiellement avec la portion du conducteur par rapport à laquelle il est dirigé de manière sensiblement perpendiculaire. Suivant la direction du courant dans la portion d'extrémité, l'interaction avec le champ magnétique local, engendré par les deux aimant entre lesquels cette portion d'extrémité est située, permettra de faire subir à l'élément planaire une rotation ou une torsion autour de l'axe AA', dans un sens ou dans l'autre.

Compte tenu de la direction des champs magnétiques, parallèles au plan 2' du substrat 2, les forces F(ω), -F(ω) qui résultent de l'interaction courant (s) - champ (s) sont donc perpendiculaires au plan 2' de ce substrat 2.

Dans cette configuration de la figure 6B, on réalise un mouvement de torsion hors plan, avec une plaque, autour d'un axe formé par deux poutres reliées au substrat par un élément mécanique en forme de U (en fait : par les branches libres du « U ») . Les aimants sont sensiblement dans le même plan que la plaque en rotation.

Dans d'autres configurations les forces qui résultent de cette interaction peuvent être dirigées dans le, ou parallèlement au, plan 2' du substrat 2 fixe.

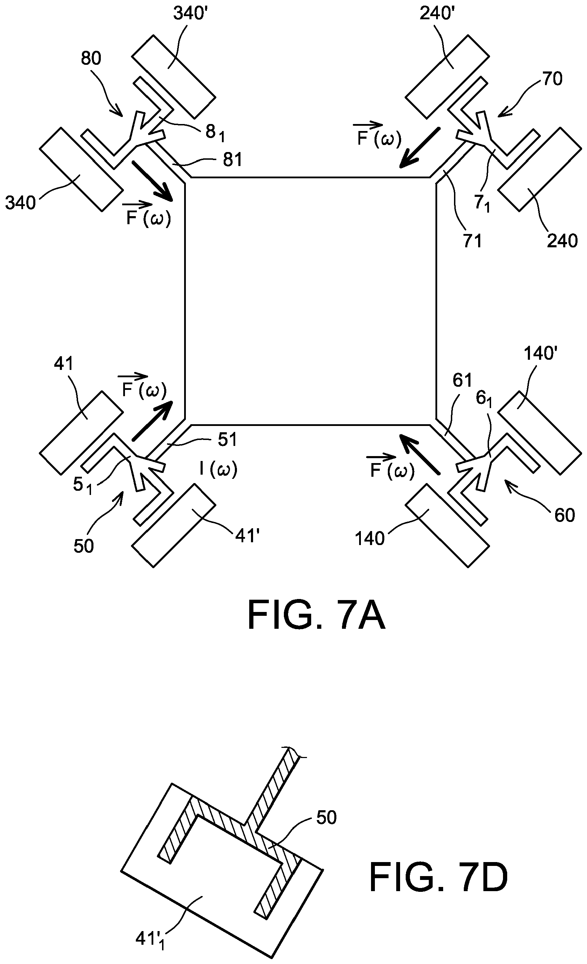

C'est le cas de la structure de la figure 7A, qui comporte n (n>1) de boucles de courant 50, 60, 70, 80, dont chacune est disposée entre deux aimants 41, 41', 140, 140', 240, 240', 340, 340' chacun à aimantation perpendiculaire au plan du substrat 2 qui les contient. Chaque boucle a en fait la forme d'un élément mécanique correspondant, et est disposée de manière sensiblement parallèle au plan 2' du substrat 2, à une extrémité d'une poutre 51, 61, 71, 81 qui va subir une force selon son axe. Cette force va donc être appliquée à tout élément situé dans la prolongation de la poutre. Sur la figure 7A, cet élément 41 est planaire, sensiblement carré ou rectangulaire (mais il peut avoir toute autre forme, par exemple celle d'un disque), et va subir les forces provenant des n (ici : n=4, mais n peut être supérieur à 1 en général) axes qui aboutissent à chaque angle de l'élément planaire. Il est donc possible d'appliquer n forces de compression ou n forces de compression/traction. Il en résulte, pour l'élément mobile 41, un effet de compression ou de dilatation.

Au niveau de chaque boucle, le champ magnétique interagit avec le courant qui circule dans la portion 5₁, 6₁, 7₁, 8₁ de la boucle qui est sensiblement perpendiculaire à la poutre 51, 61, 71, 81 à laquelle elle est reliée. Les moyens magnétiques à aimantation perpendiculaire peuvent être placés comme indiqué sur les figures 7A et 7B, à savoir un élément magnétique sous chaque branche d'extrémité de chaque élément en forme de U, et donc sous les lignes de courant (figure 7B pour la seule portion 50 et ses moyens magnétiques 41, 41'). En variante encore, on peut avoir la disposition indiquée sur les figures 7C ou 7D, à savoir avec un seul aimant à aimantation perpendiculaire disposé dans la plan du substrat 2, mais:
- soit entre les projections, sur le plan 2' du substrat 2, des branches d'extrémité de chaque élément en forme de U (figure 7C),
- soit sous l'ensemble de la projection, sur le plan 2' du substrat 2, de chaque élément en forme de U (figure 7D).

Dans les deux cas, il en résulte le même type d'interaction et le même effet que ce qui vient d'être décrit en liaison avec la figure 7A (production d'une force parallèlement au plan du substrat).

Cette structure des figures 7A - 7D permet de réaliser un mouvement de compression ou de dilatation du volume d'une plaque, avec n forces (n>1) dirigées dans le plan de cette plaque.

Pour toutes les structures proposées, on prend soin d'éloigner suffisamment les aimants placés côte à côte de façon à éviter que les champs magnétiques dipolaires utiles ne se referment sur l'aimant le plus proche.

Selon un autre mode de réalisation de l'invention on utilise un aimant 30 à aimantation réversible et un aimant 30' dont l'aimantation est figée.

Les figures 8A et 8B décrivent les architectures envisagées avec des aimants « parallèles » pour induire des mouvements hors du plan de la plaquette.

La figure 8A donne un exemple de mouvement de plaque en torsion hors du plan d'une plaquette 4 mise en rotation autour d'un axe AA' formé par deux poutres simples.

La figure 8B donne un exemple de mouvement de flexion d'une poutre ou d'une plaque 4 ancrée, libre à une de ses extrémités, hors du plan de cette poutre ou de cette plaque.

Ainsi, en figure 8A, deux aimants sont mis en oeuvre, tous deux à aimantation parallèle.

L'un (30) de ces aimants est à aimantation réversible et est placé sur, ou dans, le substrat fixe 2, sous la partie mobile 4.

Des moyens conducteurs 36 passent donc dans le substrat 2, à proximité de cet aimant 30 à aimantation réversible, afin de provoquer le chauffage et le retournement de l'aimantation.

Ce premier aimant, à aimantation réversible, est mécaniquement solidaire du support fixe alors que le second aimant (aimantation fixe) est mobile, solidaire de la partie 4, qui se déplace par rapport à l'aimant fixe.

Un mouvement de torsion, autour de l'axe AA', (mouvement de type « hors plan ») peut d'abord être obtenu. A cette fin, les aimants sont disposés, lors de la réalisation, parallèlement l'un à l'autre, pour induire ensuite des mouvements hors du plan de la plaquette (qui contient l'aimant à aimantation variable).

Plus spécifiquement, l'aimant « fixe » (mécaniquement parlant) 30 s'étend de part et d'autre d'un plan P, perpendiculaire au plan du substrat fixe 2, et comportant un axe de rotation AA' de la partie mobile. Cet axe est lui-même parallèle au plan défini par la surface 2' du substrat 2. La partie mobile comporte en outre un élément planaire 4, qui s'étend de part et d'autre de l'axe de rotation, et sur, ou dans, laquelle se trouve l'autre aimant 30', à aimantation fixe. Chacune des parties de l'élément planaire s'étend au-dessus d'une partie de l'aimant fixe, à aimantation réversible (suivant une direction Z perpendiculaire à la surface 2' du substrat 2). Le champ qui résulte de l'aimant mobile 30' à aimantation fixe va donc interagir avec le champ magnétique de l'aimant fixe 30, à aimantation réversible, au dessus duquel il est situé. Suivant la direction de l'aimantation de ce dernier, il sera possible de faire subir à l'élément planaire 4 une rotation autour de l'axe de la plaque ou une torsion de l'axe autour de l'axe AA', dans un sens ou dans l'autre. En d'autres termes, l'élément mobile subit un couple de forces électromagnétiques induites par les aimants 30, 30' (voir figure 8A). L'interaction est de type : pôle N/pôle N se repoussant ou pôle N/pôle S s'attirant.

Il est alors possible de mettre en résonance mécanique l'aimant mobile en retournant périodiquement, à la fréquence de résonance visée, les pôles de l'aimant 30 fixe mécaniquement. C'est donc le courant qui circule dans les moyens conducteurs 36 qui permet de contrôler la fréquence d'oscillation de l'élément 4 de torsion.

Dans le mode de réalisation de la figure 8B, on réalise un mouvement de flexion hors du plan de la partie mobile 4.

Là encore, on met en oeuvre un aimant 30 à aimantation réversible, à l'aide des moyens 36, placé sur ou dans le substrat fixe 2. Un aimant 30' est placé sur, ou dans, la partie mobile 4. Cette dernière a la forme d'une poutre, et elle est située, suivant l'axe Z perpendiculaire à la surface 2' du substrat 2, en face de l'aimant 30 à aimantation réversible. Lors de la réalisation, elle est disposée de manière sensiblement parallèle à la surface 2' du substrat 2. La poutre peut être encastrée d'un côté et libre de l'autre (réalisation en « cantilever »), ou encastrée des deux côtés (réalisation en «pont»).

Là encore, les champs magnétiques engendrés par les deux aimants 30, 30' sont, lors de la réalisation de la partie mobile 4, tous deux parallèles au plan du substrat 2.

L'aimant 30' disposé sur la partie mobile 4 a une aimantation fixe. Les deux champs magnétiques interagissent et la force F (attraction ou répulsion suivant le sens de l'aimantation variable) qui en résulte est perpendiculaire au plan de substrat 2. La poutre 4 vibre donc également suivant cette direction, à la fréquence imposée par le courant dans le conducteur 36.

Dans ces configurations, l'aimant mobile (ou la surface à laquelle il est lié) peut donc être soit déformable en flexion (figure 8B), soit rigide, mais tournant autour d'un axe (figure 8A).

Sur chacune des figures 8A et 8B, une seule ligne de courant a été dessinée. Néanmoins, comme déjà indiqué ci-dessus en liaison avec la figure 1A, il est possible de dissocier la ligne de courant servant à induire un champ dans l'aimant « retournable » et la ligne de courant de chauffage.

Des mouvements dans le plan d'une plaquette qui contient un aimant à aimantation variable peuvent aussi être générés.

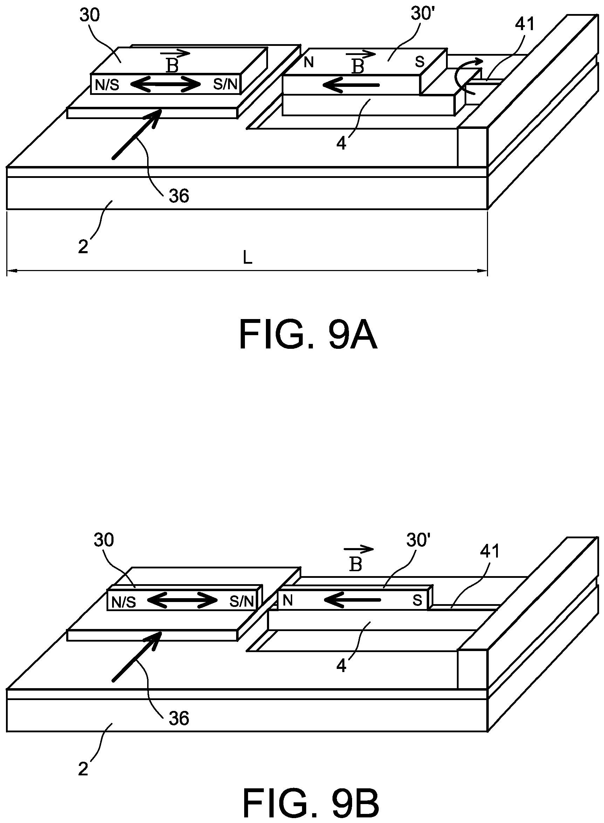

Les architectures correspondantes sont illustrées sur les figures 9A et 9B.

Ainsi, en figure 9A, un pôle de l'aimant fixe 30 (à aimantation réversible) est disposé en face d'un pôle de l'aimant 30' (à aimantation fixe) lié à la partie mobile (un élément planaire). Celle-ci est reliée au substrat, par une charnière ou un pivot 41, autour duquel elle va pouvoir pivoter dans le plan du substrat fixe 2 ou parallèlement à ce plan. Le champ qui résulte de l'aimant mobile 30' à aimantation fixe va donc interagir avec le champ magnétique de l'aimant 30 fixe, à aimantation réversible, en face duquel il est situé.

Suivant la direction de l'aimantation de ce dernier, il sera possible de faire subir à l'élément planaire un pivotement autour de la charnière ou du pivot 41, dans un sens ou dans l'autre, mais toujours parallèlement à la surface 2' du substrat 2.

En d'autres termes, l'élément mobile 4 subit un couple de forces électromagnétiques induites par les aimants 30, 30' (voir figure 9A), couple dont résulte le pivotement indiqué ci-dessus.

La figure 9B correspond au cas d'un élément mobile sous forme d'une poutre qui supporte l'aimant à aimantation fixe. Il en résulte, là encore, un mouvement en flexion, autour de l'extrémité 41 de la poutre fixée par rapport au substrat 2, dans un sens ou dans l'autre, mais toujours parallèlement à la surface 2' du substrat 2.

Dans le cas de cette figure, est réalisé un mouvement de flexion dans le plan d'une poutre, les aimants étant dans le même plan que la plaque.

Dans les cas des figures 9A et 9B, le mouvement dans le plan ou parallèlement au plan du substrat 2 est favorisé par des moyens mécaniques, par exemple par une raideur mécanique dans ce plan des moyens 41 très petite par rapport à la raideur hors de ce plan et/ou par un désalignement des aimants (de part et d'autre de l'axe charnière).

Les structures des figures 8A - 9B permettent de réaliser un nano oscillateur à actionnement magnétique, avec des aimants à aimantation parallèles et avec retournement des pôles magnétiques de l'un des aimants.

Des exemples de procédés de réalisation d'un dispositif selon l'invention vont maintenant être donnés.

Dans un premier exemple, l'aimant est réalisé dans le substrat fixe 2. Ce premier exemple conduit à la réalisation d'un dispositif qui fonctionne selon le premier mode d'actionnement décrit dessus.

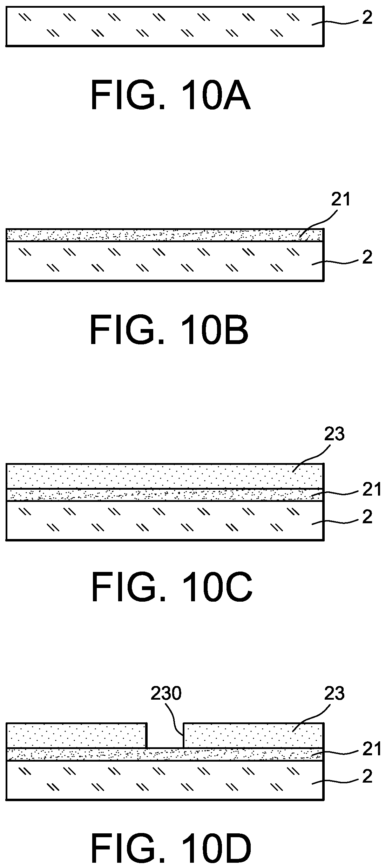

On réalise sur un substrat 2 en silicium (figure 10A) un dépôt 21 de SiN de 40 nm d'épaisseur (figure 10B), puis un dépôt 23 d'oxyde (figure 10C), par exemple de 100 nm d'épaisseur.

On procède à une étape de lithographie puis de gravure sèche de la couche d'oxyde, avec arrêt sur la couche de SiN. Est ainsi réalisé une zone gravée 230 dans laquelle sera formé l'aimant 30 (figure 10D).

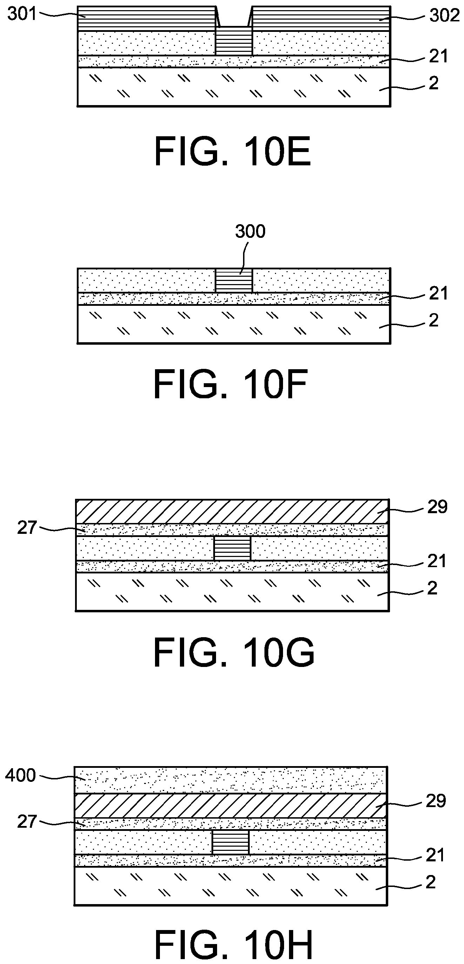

Celui-ci est ensuite réalisé par dépôt de multicouches, puis recuit (figure 10E).

Un polissage mécano-chimique, avec arrêt sur la couche 23 d'oxyde, permet d'éliminer les portions latérales 301,302 de dépôts de couches magnétiques (sur les zones non gravées de la couche 23) pour ne laisser subsister que la portion formant l'aimant 30 dans la cavité 230 (figure 10F). En variante :
- on réalise des couches magnétiques, à plat, et on les grave à la forme d'aimant souhaitée,
- puis on recouvre cette structure par une couche qui est ensuite planarisée.

Sur cette structure, on réalise, à basse température, un dépôt 27 de nitrure de Silicium et un dépôt 29 d'une couche sacrificielle, par exemple d'oxyde, d'épaisseur d'environ 50 nm (figure 10G). En variante, on peut réaliser un dépôt d'oxyde SiO2, puis un dépôt de Ti (couche sacrificielle) avec libération de cette couche par plasma XeF2. L'épaisseur de la couche sacrificielle va déterminer le « gap » entre la partie mobile et la partie fixe.

Une couche 400, par exemple en nitrure de Silicium, est ensuite déposée, dans laquelle la poutre mobile pourra être formée (figure 10H). Cette couche a sensiblement une épaisseur de 100 nm.

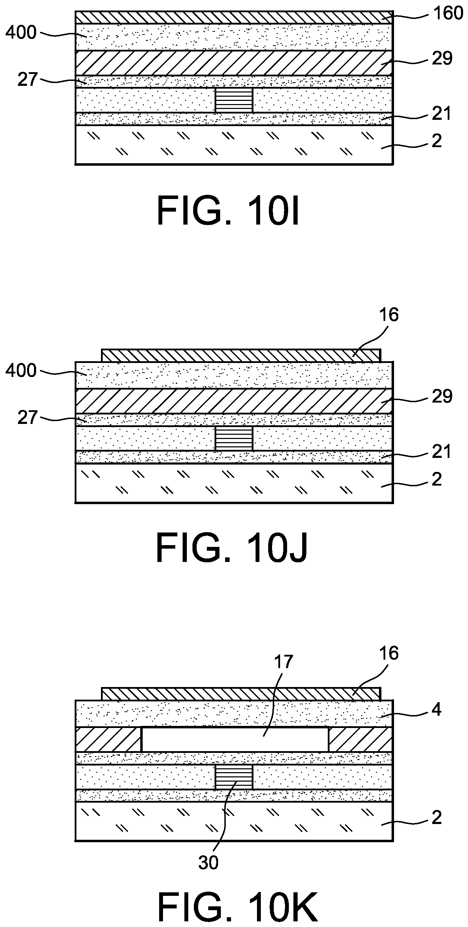

Une couche métallique 160, par exemple une couche de AlSi d'environ 100 nm d'épaisseur, est ensuite déposée (figure 10I), dans laquelle sont réalisés les lignes 16 de courant (figure 10J) par lithographie et gravure.

Une étape de lithographie et de gravure permet de structurer l'élément mécanique de la couche 400.

A l'aide d'une vapeur de HF il est procédé à l'élimination de la couche sacrificielle sous la poutre. L'espace, ou « gap », 17 entre la partie mobile et la partie fixe est donc libéré (figure 10K).

Le procédé peut aussi être accompagné d'étape de dopage pour obtenir de bons contacts ohmiques sous les plots de connexion des lignes de courant.

Les procédés sont réalisés à basse température (< 250°C) à partir du dépôt des couches magnétiques.

Des couches de protection de l'aimant peuvent aussi être réalisées, pour le protéger lors de l'étape de libération. En outre il est possible de réaliser une couche d'accroche avant toute évaporation de la première couche antiferromagnétique.

Il est possible d'utiliser d'autres matériaux pour la couche sacrificielle, les diélectriques, la poutre et le métal de la boucle de courant. Le procédé décrit ci-dessus peut être adapté selon la nature de ces matériaux.

Dans un deuxième exemple, l'aimant est réalisé sur l'élément mobile.

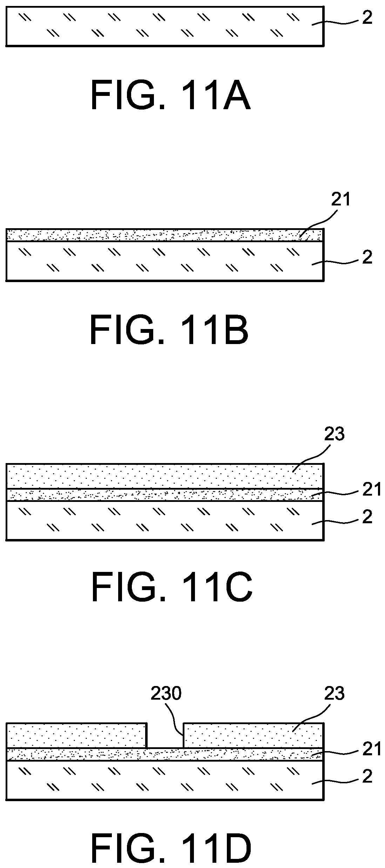

On réalise sur un substrat en silicium (figure 11A) un dépôt 21 de SiN de 40 nm d'épaisseur (figure 11B), puis un dépôt 23 d'oxyde (figure 11C), par exemple de 100 nm d'épaisseur.

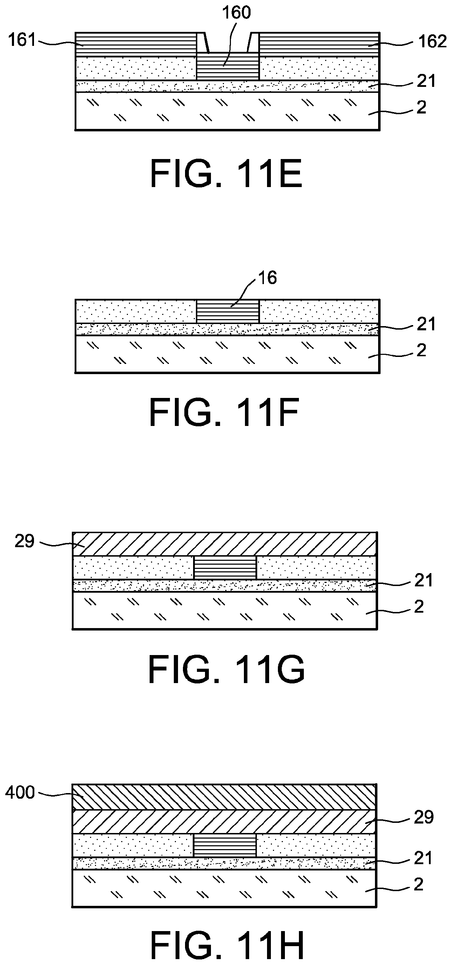

On procède à une étape de lithographie puis de gravure sèche de la couche 23 d'oxyde, avec arrêt sur la couche 21 de SiN. Est ainsi réalisée une zone gravée 230 (figure 11D), dans laquelle sera/seront formée la ou les lignes de courant 16, par dépôt métallique ou conducteur 160, par exemple un dépôt de 1 µm de TiN (figure 11E). En variante, il est possible de procéder par électrolyse.

Un polissage mécano-chimique, avec arrêt sur la couche d'oxyde, permet d'éliminer les portions latérales 161, 162 de dépôts métalliques ou conducteurs (sur les zones non gravées de la couche 23) pour ne laisser subsister que la portion formant le conducteur 16 dans la cavité 230 (figure 11F).

Sur cette structure, on réalise un dépôt d'une couche sacrificielle 29, par exemple en titane, d'épaisseur d'environ 50 nm (figure 11G). L'épaisseur de cette couche sacrificielle va déterminer le « gap » entre la partie mobile et la partie fixe.

Une couche 400, par exemple une couche métallique, dont un exemple est le ruthénium (Ru), est ensuite déposée, dans laquelle la poutre mobile 4 pourra être formée (figure 11H). Cette couche a sensiblement une épaisseur de 50 nm.

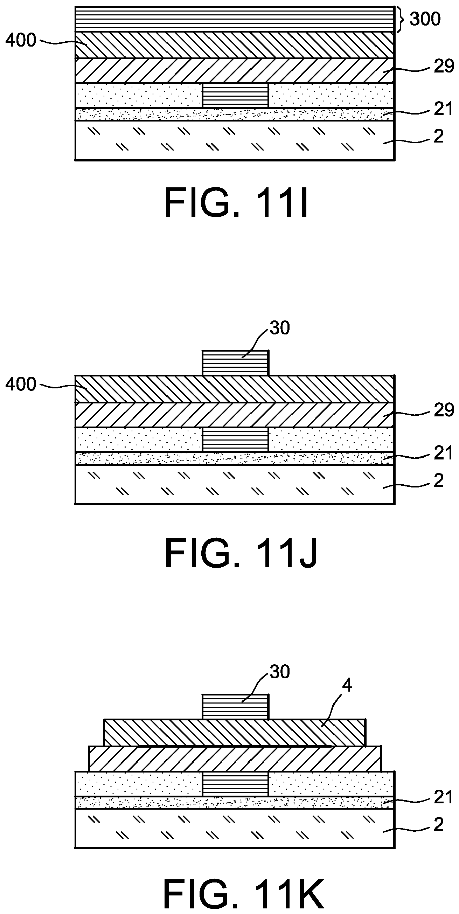

Des couches 300 en matériaux magnétiques, sont ensuite déposées (figure 11I), dans lesquelles est réalisé l'aimant 30 (figure 11J) par lithographie et gravure ionique.

La poutre 4 peut alors être lithographiée et gravée dans la couche 400 (figure 11K).

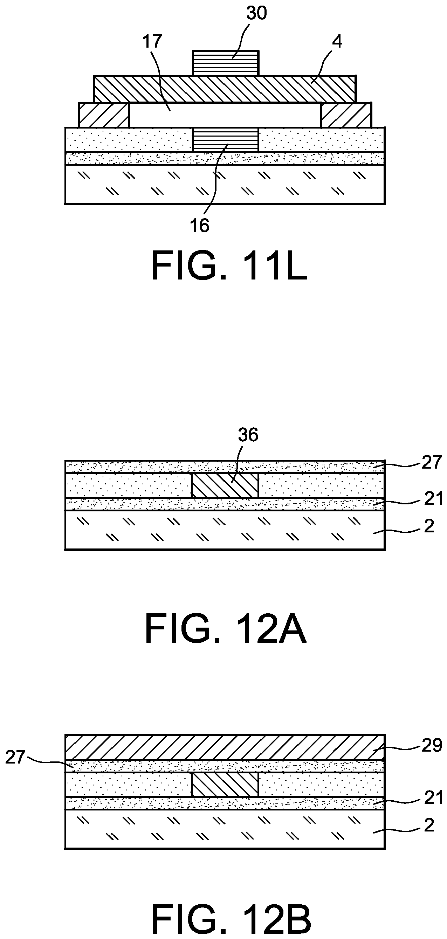

Par gravure plasma il est procédé à l'élimination de la couche sacrificielle 29 sous la poutre. L'espace ou « gap » 17 entre la partie mobile 4 et la partie fixe 2 est donc libéré (figure 11L).

Les remarques faites en liaison avec le précédent exemple s'appliquent également ici.

Dans un troisième exemple, on réalise une architecture avec retournement alternatif des pôles de l'aimant. Les lignes de courant sont réalisées avant le dépôt des couches magnétiques.

Les premières étapes permettent d'obtenir une structure identique à celle des figures 11A - 11E. Mais le conducteur obtenu est celui, 36, qui permettra de chauffer la structure magnétique 30 et d'obtenir le renversement du champ.

La figure 12A correspond donc sensiblement à la structure obtenue à l'issue de la figure 11F, et sur laquelle on ajoute une couche d'arrêt de gravure, par exemple une couche 27 de nitrure de silicium (SiN) d'environ 40 nm d'épaisseur.

Puis (figure 12B), une couche 29 d'oxyde, d'épaisseur par exemple 100 nm, est déposée sur la couche d'arrêt.

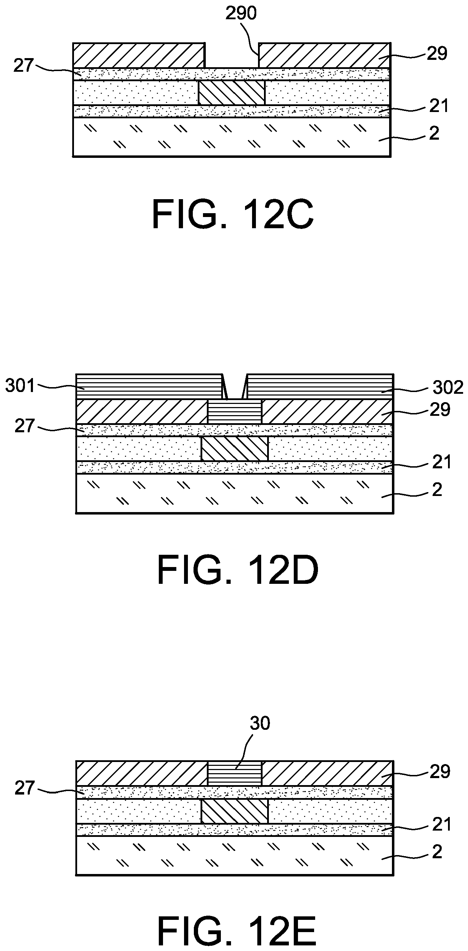

On procède à une étape de lithographie puis de gravure sèche de la couche 29 d'oxyde, avec arrêt sur la couche de SiN. Est ainsi réalisée une zone gravée 290 dans laquelle sera formé l'aimant (figure 12C) .

Celui-ci est ensuite réalisé par dépôt de multicouches, puis recuit (figure 12D).

Un polissage mécano-chimique, avec arrêt sur la couche de nitrure, permet d'éliminer les portions latérales 301, 302 de dépôts de couches magnétiques (sur les zones non gravées de la couche 27) pour ne laisser subsister que la portion formant l'aimant 30 dans la cavité 290 (figure 12E).

En variante :
- on réalise des couches magnétiques, à plat, et on les grave à la forme d'aimant souhaitée,
- puis on recouvre cette structure par une couche qui est ensuite planarisée.

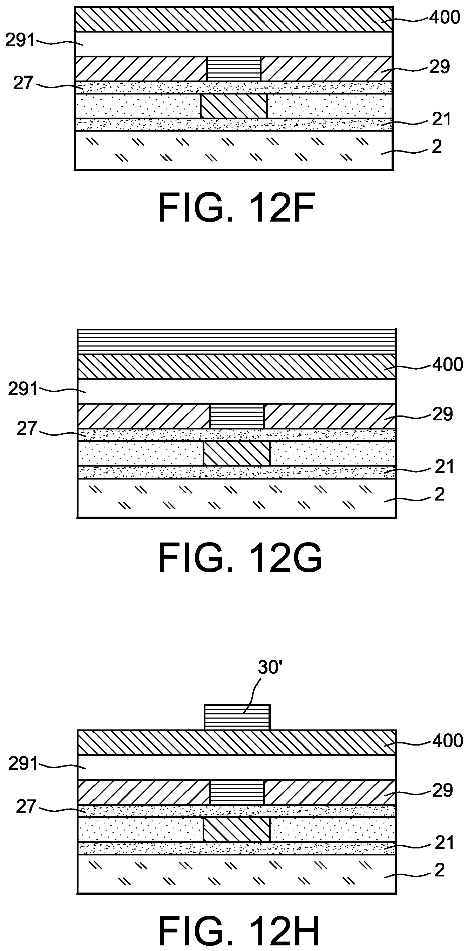

Sur cette structure, on réalise un dépôt d'une couche sacrificielle 291, par exemple en titane, d'épaisseur d'environ 50 nm (figure 12F). L'épaisseur de cette couche sacrificielle va déterminer le « gap » entre la partie mobile 4 et la partie fixe 2.

Une couche 400, par exemple une couche métallique, dont un exemple est le ruthénium (Ru), est ensuite déposée, dans laquelle la poutre mobile pourra être formée (figure 12F). Cette couche a sensiblement une épaisseur de 50 nm.

Des couches en matériaux magnétiques sont ensuite déposées (figure 12G), dans lesquelles est réalisé un deuxième aimant 30' (figure 12H) par lithographie et gravure ionique.

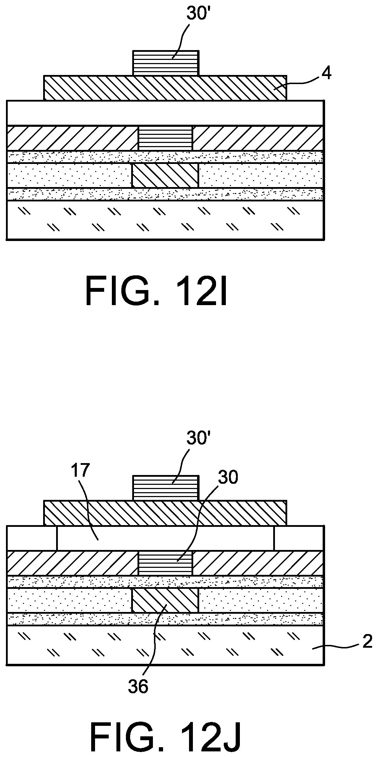

La poutre 4 peut alors être obtenue par lithographie et gravure (figure 12I).

Par gravure plasma il est procédé à l'élimination de la couche sacrificielle sous la poutre. L'espace ou « gap » 17 entre la partie mobile et la partie fixe est donc libérée (figure 12J).

Les matériaux des couches hors fabrication de l'aimant sont choisis à titre d'exemple. Il est aussi possible d'ajouter des couches de protection des aimants afin de préserver leurs intégrités lors de la libération. Il est aussi possible de faire deux couches métalliques pour structurer deux lignes de courants l'une permettant le chauffage (en intégrant une thermistance en TiN ou GeSbTe), l'autre induisant le champ de retournement (Cu par exemple).

Tous les modes de réalisation d'un dispositif suivant l'invention peuvent être réalisés à partir des techniques exposées dans les trois exemples ci-dessus. En particulier, on peut remplacer la mention d'un aimant 30 ou 30' (aimantation parallèle) par celle d'un aimant 40 ou 40' (aimantation perpendiculaire).

Les dimensions typiques d'un nano oscillateur selon l'invention sont les suivantes :
- longueur L (voir figures 3A ou 9A par exemple) de quelques micromètres (par exemple comprise entre 1µm et 5 µm ou 10 µm),
- section d'une centaine de nanomètre (par exemple comprise entre 10 nm x 10 nm et 100 nm x 50 nm, ou inférieure à 200nm x 200nm),
- les valeurs de gap ont déjà été indiquées ci-dessus.

## Revendications

1. Dispositif nano-résonateur comportant :
- au moins un élément fixe et au moins un élément mobile par rapport à l'élément fixe, le gap, ou la distance, entre partie fixe et partie mobile, lorsque cette dernière est au repos, étant inférieur à 1 *µ*m,
- des premiers moyens électromagnétiques, intégrés ou fixés à l'élément fixe, et des deuxièmes moyens électromagnétiques, intégrés ou fixés à l'élément mobile, pour générer, en interaction avec les premiers moyens électromagnétiques, un mouvement oscillant de l'élément mobile,
- au moins l'un des premier et deuxième moyens électromagnétiques comportant des moyens magnétiques de forme plane, à aimantation dans son plan ou perpendiculaire à son plan,
- au moins l'un des premier et deuxième moyens électromagnétiques comportant un empilement de couches minces, comportant une alternance d'au moins une couche de matériau ferromagnétique (F) et d'au moins une couche de matériau antiferromagnétique (AF).

2. Dispositif selon la revendication 1 :
- les premiers moyens électromagnétiques comportant au moins un conducteur de courant, et les deuxièmes moyens électromagnétiques comportant des moyens magnétiques pour engendrer une aimantation perpendiculaire à une direction de circulation du courant dans ledit conducteur,
- ou bien : les deuxièmes moyens électromagnétiques comportant au moins un conducteur de courant et les premiers moyens électromagnétiques comportant des moyens magnétiques pour engendrer une aimantation perpendiculaire à une direction de circulation du courant dans ledit conducteur.

3. Dispositif nano-résonateur selon la revendication 2, comportant en outre des moyens pour faire circuler un courant alternatif dans le conducteur de courant (16), par exemple à au moins une fréquence égale à, ou proche de, une fréquence de résonnance mécanique de la partie mobile.

4. Dispositif nano-résonateur selon l'une des revendications 2 ou 3, les moyens magnétiques (30, 30') comportant au moins un aimant de forme plane, à aimantation dans son plan.

5. Dispositif nano-résonateur selon l'une des revendications 1 à 4, dans lequel au moins l'un desdits premiers ou deuxièmes moyens électromagnétiques est à aimantation réversible et est associé à des moyens (36,37) de retournement de l'aimantation.

6. Dispositif selon la revendication 5, comportant en outre des moyens (36) pour chauffer au moins une couche, par exemple en matériau antiferromagnétique (AF), au-dessus de la température de blocage de cette couche.

7. Dispositif nano-résonateur selon l'une des revendications 2 à 5, les moyens magnétiques (40, 40') comportant au moins un aimant de forme plane, à aimantation perpendiculaire à son plan.

8. Dispositif selon la revendication 7, les moyens magnétiques à aimantation perpendiculaire comportant une pluralité de couches CoPt.

9. Dispositif selon l'une des revendications 7 ou 8, comportant des moyens pour retourner l'aimantation desdits moyens magnétiques à aimantation perpendiculaire.

10. Dispositif nano-résonateur selon la revendication 1:
- les premiers moyens électromagnétiques comportant des premiers moyens magnétiques de forme plane, à aimantation dans leur plan, disposé respectivement sur ou dans l'élément mobile ou l'élément fixe,
- les deuxièmes moyens électromagnétiques comportant des deuxièmes moyens magnétiques (30, 30'), de forme plane, à aimantation dans leur plan, disposés respectivement sur ou dans l'élément fixe ou l'élément mobile,
- l'un au moins des premiers et des deuxièmes moyens magnétiques étant à aimantation réversible et comportant en outre des moyens pour retourner cette aimantation.

11. Dispositif selon la revendication 10, l'empilement étant limité par deux couches externes dont chacune est une couche antiferromagnétique, les moyens pour retourner l'aimantation comportant des moyens pour chauffer la couche de matériau antiferromagnétique (AF) au-dessus de la température de blocage de cette couche.

12. Dispositif nano-résonateur selon l'une des revendications 10 ou 11, l'élément fixe et l'élément mobile étant sensiblement dans un même plan.

13. Dispositif selon l'une des revendications 1 à 12 :
- l'élément mobile étant en forme de poutre ou de plaque, dont une extrémité au moins est fixe par rapport à l'élément fixe,
- ou l'élément mobile comportant un axe (AA') de rotation, et une partie plane (4'), pouvant être mise en rotation autour de cet axe.

14. Dispositif selon l'une des revendications 1 à 13, l'élément mobile comportant un axe (AA') de rotation, et une partie plane (4'), pouvant être mise en rotation autour de cet axe, le conducteur de courant, intégré ou fixé à l'élément mobile étant disposé sur, ou intégré à, une portion d'extrémité de l'axe (AA') de rotation, disposée entre deux aimants.

## Patentansprüche

1. Nano-Resonator-Vorrichtung, enthaltend:
- zumindest ein festes Element und zumindest ein bezüglich des festen Elements bewegliches Element, wobei der Spalt bzw. Abstand zwischen dem festen Teil und dem beweglichen Teil, wenn letzteres in Ruhestellung ist, geringer als 1 µm ist,
- erste elektromagnetische Mittel, die in das feste Element integriert bzw. daran befestigt sind, und zweite elektromagnetische Mittel, die in das bewegliche Element integriert bzw. daran befestigt sind, um in Wechselwirkung mit den ersten elektromagnetischen Mitteln eine oszillierende Bewegung des beweglichen Elements zu erzeugen,
- wobei zumindest eines aus erstem und zweitem elektromagnetischen Mittel magnetische Mittel von flacher Form mit Magnetisierung in seiner Ebene oder senkrecht zu seiner Ebene enthalten,
- wobei zumindest eines aus erstem und zweitem elektromagnetischen Mittel eine Stapelung von Dünnschichten aufweist, die eine Wechselfolge von zumindest einer Schicht aus ferromagnetischem Material (F) und zumindest einer Schicht aus antiferromagnetischem Material (AF) aufweist.

2. Vorrichtung nach Anspruch 1, wobei:
- die ersten elektromagnetischen Mittel zumindest einen Stromleiter aufweisen und die zweiten elektromagnetischen Mittel magnetische Mittel aufweisen, um eine Magnetisierung senkrecht zu einer Fließrichtung des Stroms in dem Leiter zu bewirken,
- oder die zweiten elektromagnetischen Mittel zumindest einen Stromleiter aufweisen und die ersten elektromagnetischen Mittel magnetische Mittel aufweisen, um eine Magnetisierung senkrecht zu einer Fließrichtung des Stroms in dem Leiter zu bewirken.

3. Nano-Resonator-Vorrichtung nach Anspruch 2, ferner enthaltend Mittel, um in dem Stromleiter (16) einen Wechselstrom beispielsweise mit zumindest einer Frequenz gleich oder nahe einer mechanischen Resonanzfrequenz des beweglichen Teils fließen zu lassen.

4. Nano-Resonator-Vorrichtung nach einem der Ansprüche 2 oder 3, wobei die magnetischen Mittel (30, 30') zumindest ein Magnet von flacher Form mit Magnetisierung in seiner Ebene enthalten.

5. Nano-Resonator-Vorrichtung nach einem der Ansprüche 1 bis 4, wobei zumindest eines der ersten bzw. zweiten elektromagnetischen Mittel mit reversibler Magnetisierung ausgeführt ist, dem Mittel (36, 37) zum Umkehren der Magnetisierung zugeordnet sind.

6. Vorrichtung nach Anspruch 5, ferner enthaltend Mittel (36), um zumindest eine Schicht, beispielsweise aus antiferromagnetischem Material (AF), über die Temperatur der Blockierung dieser Schicht zu erhitzen.

7. Nano-Resonator-Vorrichtung nach einem der Ansprüche 2 bis 5, wobei die magnetischen Mittel (40, 40') zumindest ein Magnet von flacher Form mit Magnetisierung senkrecht zu seiner Ebene enthalten.

8. Vorrichtung nach Anspruch 7, wobei die magnetischen Mittel mit senkrechter Magnetisierung eine Mehrzahl von CoPt-Schichten enthalten.

9. Vorrichtung nach einem der Ansprüche 7 oder 8, enthaltend Mittel zum Umkehren der Magnetisierung der magnetischen Mittel mit senkrechter Magnetisierung.

10. Nano-Resonator-Vorrichtung nach Anspruch 1, wobei
- die ersten elektromagnetischen Mittel erste magnetische Mittel von flacher Form mit Magnetisierung in ihrer Ebene enthalten, die jeweils an oder in dem beweglichen Element oder festen Element angeordnet sind,
- die zweiten elektromagnetischen Mittel zweite magnetische Mittel (30, 30') von flacher Form mit Magnetisierung in ihrer Ebene enthalten, die jeweils an oder in dem festen Element oder beweglichen Element angeordnet sind,
- wobei zumindest eines aus ersten und zweiten magnetischen Mitteln mit reversibler Magnetisierung ausgeführt ist und zumindest ferner Mittel zum Umkehren dieser Magnetisierung enthält.

11. Vorrichtung nach Anspruch 10, wobei die Stapelung von zwei Außenschichten eingegrenzt wird, die jeweils eine antiferromagnetische Schicht sind, wobei die Mittel zum Umkehren der Magnetisierung Mittel zum Erhitzen der Schicht aus antiferromagnetischem Material (AF) über die Temperatur der Blockierung dieser Schicht enthalten.

12. Nano-Resonator-Vorrichtung nach einem der Ansprüche 10 oder 11, wobei das feste Element und das bewegliche Element im Wesentlichen in einer gleichen Ebene liegen.

13. Vorrichtung nach einem der Ansprüche 1 bis 12, wobei:
- das bewegliche Element in Balken- oder Plattenform vorliegt, von der zumindest ein Ende bezüglich des festen Elements fest ist,
- oder das bewegliche Element eine Rotationsachse (AA') und einen flachen Teil (4') aufweist, der um diese Achse in Drehung versetzt werden kann.

14. Vorrichtung nach einem der Ansprüche 1 bis 13, wobei das bewegliche Element eine Rotationsachse (AA') und einen flachen Teil (4') aufweist, der um diese Achse in Drehung versetzt werden kann, wobei der in das bewegliche Element integrierte oder daran befestigte Stromleiter an einem zwischen zwei Magneten angeordneten Endabschnitt der Rotationsachse (AA') angeordnet oder darin integriert ist.

## Claims

1. Nano-resonator device comprising:
- at least one fixed element and at least one mobile element with respect to the fixed element, the distance between the mobile element and the fixed element being, when the fixed element is idle, less than 1 µm,
- first electromagnetic means, integrated or fixed on the fixed element, and second electromagnetic means, integrated or fixed on the mobile element, to generate, in interaction with the first electromagnetic means, an oscillating movement of the mobile element,
- at least one of the first and second electromagnetic means comprising plane shaped magnetic means, with magnetization in the plane thereof or perpendicular to the plane thereof,
- at least one of said first or second electromagnetic means comprises a stack of layers, comprising an alternation of at least one magnetic layer (F) and at least one anti-ferromagnetic layer (AF).

2. Device according to claim 1:
- the first electromagnetic means comprising at least one current conductor, and the second electromagnetic means comprising magnetic means to generate magnetization perpendicular to a direction of flow of the current in said conductor;
- or the second electromagnetic means comprising at least one current conductor and the first electromagnetic means comprising magnetic means to generate magnetization perpendicular to a direction of flow of the current in said conductor.

3. Nano-resonator device according to claim 2, also comprising means for circulating an alternating current in the current conductor (16), for example at at least one frequency equal to, or close to, a mechanical resonance frequency of the mobile part.

4. Nano-resonator device according to one of claims 2 or 3, the magnetic means (30, 30') comprising at least one plane shaped magnet, with magnetization in the plane thereof.

5. Nano-resonator device according to any of claims 1 to 4, wherein at least one of said first or second electromagnetic means having reversible magnetization and being associated with magnetization reversal means (36, 37).

6. Nano-resonator device according to claim 5, also comprising means (36) for heating at least one layer of anti-ferromagnetic material (AF) above the blocking temperature of said layer.

7. Nano-resonator device according to any of claims 2 to 5, the magnetic means (40, 40') comprising at least one plane shaped magnet, with magnetization perpendicular to the plane thereof.

8. Device according to claim 7, the perpendicular magnetization magnetic means comprising a plurality of CoPt layers.

9. Device according to claim 7 or 8, comprising means to reverse the magnetization of said perpendicular magnetization magnetic means.

10. Nano-resonator device according to claim 1:
- the first electromagnetic means comprising first plane shaped magnetic means, with magnetization in the plane thereof, arranged respectively on or in the mobile element or the fixed element;
- the second electromagnetic means comprising second plane shaped magnetic means (30, 30'), with magnetization in the plane thereof, arranged respectively on or in the fixed element or the mobile element,
- at least one of the first and second magnetic means having reversible magnetization and also comprising means for reversing said magnetization.

11. Device according to claim 10, the stack being limited by two external layers wherein each is an anti-ferromagnetic layer, the means for reversing the magnetization comprising means for heating the layer of anti-ferromagnetic material above the blocking temperature of said layer.

12. Nano-resonator device according to claim 10 or 11, the fixed element and the mobile element moving substantially in the same plane.

13. Device according to one of claims 1 to 12:
- the mobile element being in the form of a beam or plate, of which one end at least is fixed with respect to the fixed element;
- or the mobile element comprising an axis (AA') of rotation, and a plane part (4'), that can be rotated about said axis.

14. Device according to any of claims 1 to 13, the mobile element comprising an axis (AA') of rotation, and a plane part (4'), that can be rotated about said axis, the current conductor, integrated or fixed on the mobile element being arranged on, or integrated in, an end portion of the axis (AA') of rotation, arranged between two magnets.
